# EUROPEAN PATENT APPLICATION

(11) **EP 4 474 912 A2**
(43) Date of publication of application: **11.12.2024**
(21) Application number: 24178243.2
(22) Date of filing: 27.05.2024
(51) Int. Cl.: G03F 7/09, G03F 7/40

(54) **PATTERN FORMING METHOD**

(30) Priority: 06.06.2023 JP 2023093543; 09.11.2023 JP 2023191843
(71) Applicant: Shin-Etsu Chemical Co., Ltd., Tokyo 100-0005 (JP)
(72) Inventor: Kobayashi, Naoki, Niigata (JP); Takizawa, Kanata, Niigata (JP); Satoh, Hironori, Niigata (JP); Iwamori, Shohei, Niigata (JP); Kori, Daisuke, Niigata (JP)
(74) Representative: Sonnenhauser, Thomas Martin

(57) **Abstract**

The present invention is a pattern forming method including steps of: forming a resist underlayer film by using a composition for forming a resist underlayer film on a substrate to be processed; forming a resist middle layer film on the resist underlayer film; forming a resist upper layer film on the resist middle layer film; forming a pattern in the resist upper layer film; transferring the pattern to the resist middle layer film; transferring the pattern to the resist underlayer film; forming the pattern in the substrate to be processed; trimming the resist underlayer film; and forming a staircase-shaped pattern in the substrate to be processed. The composition for forming a resist underlayer film contains a resin and an organic solvent. The resin represented by the following formula (1) is used. This provides: a pattern forming method capable of accurately forming a staircase-shaped pattern by using a composition for forming a resist underlayer film having excellent dry-etching resistance over conventional KrF resists and having excellent film formability and substrate adhesion.

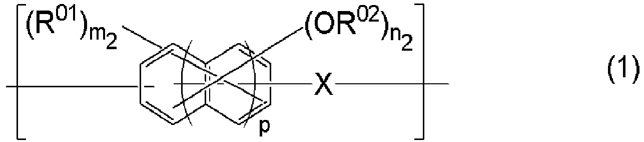

## Description

### TECHNICAL FIELD

The present invention relates to a pattern forming method.

### BACKGROUND ART

Integrated circuit (IC) industry has realized low bit cost by shifting to smaller shapes. However, further reduction in critical dimension has not been realized by current lithography technologies with equally low fabrication costs. NAND flash manufacturers have been examining technologies for reducing fabrication cost per bit while implementing large storage capacity by stacking multiple layers of memory cells. Stacked 3D structures for NAND applications have been developed by miniaturizing important features with reduced fabrication costs. Such 3D NAND devices have a higher density and are faster and cheaper than conventional 2D planar NAND devices.

Fabrication of three-dimensional stacked semiconductor memories such as 3D NAND flash memories involves a process of etching a multilayer film into a staircase shape by using plasma. In the process of etching a multilayer film into a staircase shape, etching of the multilayer film having a mask on its surface and trimming of the mask on the multilayer film are alternately performed. A thick KrF photoresist that enables multiple trimming and etching cycles is used as the mask (Patent Document 1).

On the other hand, 3D NAND architectures have shifted from 64 vertical layers to more than 128 layers and require thicker resists. The use of a thick resist film in KrF lithography for resolving a pattern in a micrometer scale involves unique technical problems. To pattern a thick resist film, a sufficient film transmittance with an exposure wavelength (248 nm) is required so that incident radiation can reach the bottom of the film. Moreover, a thick resist film used in 3D NAND applications undergoes a series of "pull back" etching processes in vertical and horizontal directions in each step.

Patent Document 2 has reported a 15 µm thick KrF resist. However, an etching process performed on the thick resist film may affect uniformity in film structure and may increase roughness in a cross section of the staircase shape. A suitable mask should maintain the physical structure of the film after each etching process. For further multi-layering in the future, etching merely using a conventional resist film seems to approach the limit of application.

One of solutions to solve such a problem is a multilayer resist method. In this method, a resist underlayer film having etching selectivity different from that of a photoresist film (that is, a resist upper layer film) is placed between the resist upper layer film and a substrate to be processed; a pattern is formed in the resist upper layer film; then, the pattern is transferred to the resist underlayer film by dry-etching using the resist upper layer film pattern as a dry-etching mask; and the pattern is further transferred to the substrate to be processed by dry-etching using the resist underlayer film as a dry etching mask.

One of the multilayer resist methods is a three-layer resist method, which can be performed with a typical resist composition used in a monolayer resist method. For example, in the three-layer resist method, an organic film made of a novolac resin or the like is formed as a resist underlayer film on a substrate to be processed; a silicon-containing resist middle layer film is formed as a resist middle layer film on the resist underlayer film; and a usual organic photoresist film is formed as a resist upper layer film on the resist middle layer film. Since the organic resist upper layer film exhibits a favorable etching selectivity ratio relative to the silicon-containing resist middle layer film in dry-etching with fluorine-based gas plasma, the resist upper layer film pattern can be transferred to the silicon-containing resist middle layer film by dry-etching with fluorine-based gas plasma. According to this method, even when a resist composition to be used has difficulty in forming a pattern with a sufficient film thickness for directly processing the substrate to be processed or has insufficient dry-etching resistance for processing the substrate, the pattern can be transferred to the silicon-containing resist middle layer film (resist middle layer film). Subsequently, pattern transfer by dry-etching with oxygen-based or hydrogen-based gas plasma is performed, resulting in a pattern of the organic film (resist underlayer film) made of a novolac resin or the like having sufficient dry-etching resistance for processing the substrate.

One of problems with using the three-layer resist method to form a staircase-shaped pattern is to achieve both film formability and dry-etching resistance in forming a thick resist underlayer film. The composition for forming a resist underlayer film contains a polymer having a rigid aromatic ring structure and thus exhibits excellent dry-etching resistance (Patent Document 3). However, because of a rigid structure, film formation failures such as cracking tend to occur in thick film formation. Since the resin having a phenolic hydroxyl group has an increased complex viscosity, the flowability of the composition for forming a resist underlayer film is reduced, which makes it difficult to form a thick film in one application. On the other hand, it has been reported that the use of a resin modified with a phenolic hydroxyl group achieves excellent flowability (Patent Document 4). However, when a thick film is formed using such a resin modified with a phenolic hydroxyl group as a resist underlayer film, the adhesion to the substrate is insufficient, which may cause separation from the substrate.

### CITATION LIST

### PATENT LITERATURE

Patent Document 1: JP 2020-187352 A
Patent Document 2: JP 2021-063217 A
Patent Document 3: JP 2005-128509 A
Patent Document 4: JP 2017-119671 A

### SUMMARY OF INVENTION

### TECHNICAL PROBLEM

In view of the circumstances, the present invention aims to provide a pattern forming method capable of accurately forming a staircase-shaped pattern by using a composition for forming a resist underlayer film having excellent dry-etching resistance over conventional KrF resists and having excellent film formability and substrate adhesion.

### SOLUTION TO PROBLEM

To achieve the object, the present invention provides a pattern forming method in which a pattern is formed in a substrate to be processed. The pattern forming method includes steps of:
(I-1) applying a composition for forming a resist underlayer film on a substrate to be processed and thereafter performing heat treatment to form a resist underlayer film;
(I-2) forming a silicon-containing resist middle layer film on the resist underlayer film;
(1-3) forming a resist upper layer film by using a photoresist material on the silicon-containing resist middle layer film;
(I-4) performing pattern exposure and subsequent development with a developer in the resist upper layer film to form a pattern in the resist upper layer film;
(1-5) transferring a pattern to the silicon-containing resist middle layer film by dry-etching while using the resist upper layer film having the pattern as a mask;
(I-6) transferring a pattern to the resist underlayer film by dry-etching while using the silicon-containing resist middle layer film having the transferred pattern as a mask;
(1-7) processing the substrate to be processed while using the resist underlayer film having the transferred pattern as a mask to form a pattern in the substrate to be processed;
(I-8) trimming the resist underlayer film having the transferred pattern; and
(I-9) processing the substrate to be processed while using the trimmed resist underlayer film pattern as a mask to form a staircase-shaped pattern in the substrate to be processed, wherein

the composition for forming a resist underlayer film contains a resin (A) and an organic solvent (B), the resin (A) has a constitutional unit represented by the following general formula (1), and when a phenolic hydroxyl group contained in the resin (A) has a proportion "a" and a group in which a phenolic hydroxyl group is modified has a proportion "b", a relation: a+b=1, 0.1≤a≤0.5, and 0.5≤b≤0.9 is satisfied, 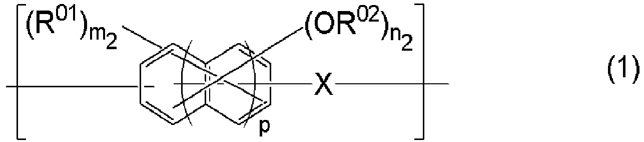 wherein R⁰¹ represents an optionally substituted saturated or unsaturated monovalent organic group having 1 to 30 carbon atoms; R⁰² represents a hydrogen atom or an optionally substituted saturated or unsaturated monovalent organic group having 1 to 30 carbon atoms; X represents a divalent organic group having 1 to 30 carbon atoms; "p" represents 0 or 1, wherein when "p" is 0, "m₂" represents an integer of 0 to 3, "n₂" represents an integer of 1 to 4, and m₂+n₂ represents an integer of 1 or greater and 4 or smaller, and when "p" is 1, "m₂" represents an integer of 0 to 5, "n₂" represents an integer of 1 to 6, and m₂+n₂ represents an integer of 1 or greater and 6 or smaller.

Such a pattern forming method can provide excellent flowability and substrate adhesion. Adjusting the proportions of the structure within the above range can form a thick resist underlayer film with good film formability. Further, even when the substrate to be processed has steps, the steps of the substrate to be processed can be filled with no voids, resulting in a flat film. In addition, since a thick resist underlayer film having excellent dry-etching resistance over conventional KrF resists can be formed, the resist pattern can be accurately transferred to the substrate to be processed.

In the present invention, it is preferable that the steps (I-8) to (I-9) are repeated to form a plurality of staircase-shaped patterns in the substrate to be processed.

With such a pattern forming method, a staircase-shaped pattern can be accurately transferred to the substrate to be processed.

In the present invention, it is preferable that a multilayer film having stacked polysilicon layers, or a multilayer film having a SiN layer and a SiO layer alternately stacked is used as the substrate to be processed.

Such a pattern forming method is suitable for fabrication of three-dimensional stacked semiconductor memories such as 3D NAND flash memories.

In the present invention, it is preferable that a multilayer film having a polysilicon layer and a SiO layer alternately stacked, or a multilayer film having a SiN layer and a SiO layer alternately stacked is used as the substrate to be processed.

Such a pattern forming method is suitable for fabrication of three-dimensional stacked semiconductor memories such as 3D NAND flash memories.

In the present invention, it is preferable that a resist underlayer film having a thickness of at least 3 µm is formed as the resist underlayer film.

With such a pattern forming method, many staircase-shaped patterns can be accurately transferred to the substrate to be processed.

In this case, it is preferable that in the step (I-1), the resist underlayer film is coated to a thickness of at least 3 µm in one application.

Such a pattern forming method is preferable because by applying the composition for forming a resist underlayer film once, many staircase-shaped patterns can be accurately transferred to the substrate to be processed.

In the present invention, it is preferable that a resin having a weight average molecular weight of 3,000 to 20,000 is used as the resin (A).

Because of the inclusion of such a resin (A), a thick resist underlayer film having excellent film formability and film thickness uniformity can be formed.

In the present invention, it is preferable that a composition containing a base generator (C) is used as the composition for forming a resist underlayer film.

Such a pattern forming method can form a thick resist underlayer film with excellent substrate adhesion.

It is preferable that any one represented by the following general formulae (2), (3), and (4) is used as the base generator (C), 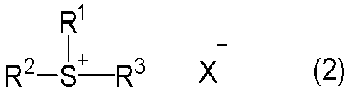 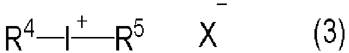 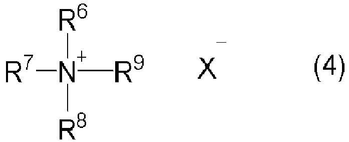 wherein R¹ to R³ each independently represent a linear, branched, or cyclic alkyl group having 1 to 10 carbon atoms or alkenyl group having 2 to 10 carbon atoms, which may be substituted with or separated by a hetero atom, or represent an aryl group having 6 to 18 carbon atoms or aralkyl group having 7 to 18 carbon atoms, which may be substituted with or separated by a hetero atom; any two of R¹, R², and R³ may bond together to form a ring with a sulfur atom in the formula; X⁻represents an organic or inorganic anion serving as a pairing ion, provided that X⁻ does not include OH⁻; R⁴ and R⁵ are each independently an aryl group having 6 to 20 carbon atoms, which may be substituted with or separated by a hetero atom, in which part or all of hydrogen atoms may be substituted with a linear, branched, or cyclic alkyl group or alkoxy group having 1 to 10 carbon atoms; R⁴ and R⁵ may bond together to form a ring with an iodine atom in the formula; R⁶, R⁷, R⁸, and R⁹ each independently represent a hydrogen atom, or a linear, branched, or cyclic alkyl group having 1 to 20 carbon atoms or alkenyl group having 2 to 20 carbon atoms, which may be substituted with or separated by a hetero atom, or represent an aryl group having 6 to 18 carbon atoms or aralkyl group having 7 to 18 carbon atoms, which may be substituted with or separated by a hetero atom; and any two or more of R⁶, R⁷, R⁸, and R⁹ may bond together to form a ring with a nitrogen atom in the formula.

With such a pattern forming method using the composition for forming a resist underlayer film containing the base generator (C), a thick resist underlayer film with more excellent substrate adhesion can be formed.

In this case, it is preferable that one of: a structure represented by any one of the following general formulae (5), (6), and (7); and an anion selected from the group consisting of chloride ion, bromide ion, iodide ion, fluoride ion, cyanide ion, nitrate ion, and nitrite ion is used as X⁻ in the general formulae (2), (3), and (4),

R¹⁰-COO (5)

R¹¹-SO₃⁻ (6)

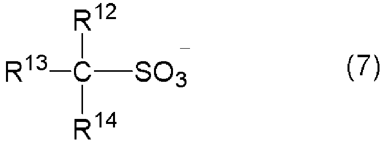

wherein R¹⁰ represents a linear, branched, or cyclic alkyl group having 1 to 20 carbon atoms, alkenyl group having 2 to 20 carbon atoms, aryl group having 6 to 20 carbon atoms, or aralkyl group having 7 to 20 carbon atoms, which may contain one or more selected from an ether group, an ester group, and a carbonyl group, and part or all of hydrogen atoms in these groups may be substituted with one or more selected from a halogen atom, a hydroxyl group, a carboxy group, an amino group, and a cyano group; R¹¹ represents an aryl group having 6 to 20 carbon atoms, and part or all of hydrogen atoms in the aryl group may be substituted with one or more selected from a halogen atom, a hydroxyl group, a carboxy group, an amino group, and a cyano group; R¹², R¹³, and R¹⁴ each independently represent a hydrogen atom, a halogen atom except fluorine atom, or a linear, branched, or cyclic alkyl group having 1 to 20 carbon atoms, alkenyl group having 2 to 20 carbon atoms, aryl group having 6 to 20 carbon atoms, or aralkyl group having 7 to 20 carbon atoms, which may contain one or more selected from an ether group, an ester group, and a carbonyl group, and part or all of hydrogen atoms in these groups may be substituted with one or more selected from a halogen atom, a hydroxyl group, a carboxy group, an amino group, and a cyano group; and two or more of R¹², R¹³, and R¹⁴ may bond together to form a ring.

With such a pattern forming method using the composition for forming a resist underlayer film containing the base generator (C), a thick resist underlayer film with even more excellent substrate adhesion can be formed.

In the present invention, it is preferable that in the general formula (1), R⁰² represents any one of a hydrogen atom, an alkyl group having 1 to 10 carbon atoms, and a structure represented by the following general formulae (8), 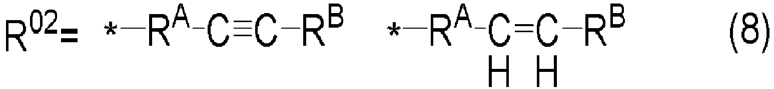 wherein * represents a bonding site with an oxygen atom; R^{A} represents an optionally substituted divalent organic group having 1 to 10 carbon atoms; and R^{B} represents a hydrogen atom or an optionally substituted monovalent organic group having 1 to 10 carbon atoms.

In the pattern forming method using the resin (A) having such a structure, excellent flowability can be imparted to the composition for forming a resist underlayer film and thus a thick resist underlayer film exhibiting good film formability can be formed.

In the present invention, it is preferable that a composition further containing one or more selected from a crosslinking agent (D), a flowability accelerator (E), and a surfactant (F) is used as the composition for forming a resist underlayer film.

The composition for forming a resist underlayer film containing the above additive(s) can be used to adjust physical properties required when forming a resist underlayer film, such as film formability, filling property, dry-etching resistance, and substrate adhesion, in appropriate ranges.

In the present invention, it is preferable that photolithography with a wavelength of 5 nm to 300 nm, direct drawing by electron beams, nano-imprinting, or a combination thereof is used as a method of forming a circuit pattern in the resist upper layer film.

Such a pattern forming method can form a pattern with less edge roughness.

In the present invention, it is preferable that alkaline development or development by an organic solvent is used as a development method.

Such a pattern forming method can form a pattern with less edge roughness and with less residue of a resist dissolution portion.

In the present invention, it is preferable that a substrate having a structure or a step with an aspect ratio of 5 or more is used as the substrate to be processed.

The pattern forming method of the present invention, which uses a composition for forming a resist underlayer film having high filling property, is useful in particular for microfabrication for a substrate having such a structure or step and is suitable for a process for forming a complicated staircase-shaped pattern.

### ADVANTAGEOUS EFFECTS OF INVENTION

As described above, the pattern forming method of the present invention, which uses a composition for forming a resist underlayer film having excellent dry-etching resistance over conventional KrF resists and having excellent film formability and substrate adhesion, is extremely useful in fine patterning for semiconductor device fabrication. In particular, in a fine patterning process by a multilayer resist method in a semiconductor device fabrication process, it is possible to provide a pattern forming method using a composition for forming a resist underlayer film that has excellent filling property and can form a resist underlayer film without failures such as voids and separation even on a substrate to be processed having a portion with a large aspect ratio and particularly difficult to be filled, as typified by 3D NAND memories with more and more layers stacked, and, in addition, has appropriate planarizing, etching, and optical properties.

### BRIEF DESCRIPTION OF DRAWINGS

FIG. 1 is an illustration of an example of a pattern forming method (three-layer resist process) of the present invention; and
FIG. 2 is an illustration of a filling property evaluation method.

### DESCRIPTION OF EMBODIMENTS

As described above, there has been a demand for a pattern forming method capable of accurately forming a staircase-shaped pattern in a process in which a multilayer film are etched into a staircase shape, as typified by 3D NAND memories with more and more layers.

The inventors of the present invention have conceived that a staircase-shaped pattern can be accurately formed in a substrate to be processed by using a multilayer resist method using a resist underlayer film. On the other hand, the inventors have searched for a pattern forming method using various compositions for forming a resist underlayer film in order to achieve both of film formability and dry-etching resistance, which have been challenges in forming a thick resist underlayer film. As a result, it has been found that a pattern forming method using a resist underlayer film material containing a resin having a particular structure is very effective. This finding has led to completion of the present invention.

Specifically, the present invention provides a pattern forming method in which a pattern is formed in a substrate to be processed. The pattern forming method includes steps of:
(I-1) applying a composition for forming a resist underlayer film on a substrate to be processed and thereafter performing heat treatment to form a resist underlayer film;
(I-2) forming a silicon-containing resist middle layer film on the resist underlayer film;
(I-3) forming a resist upper layer film by using a photoresist material on the silicon-containing resist middle layer film;
(I-4) performing pattern exposure and subsequent development with a developer in the resist upper layer film to form a pattern in the resist upper layer film; (I-5) transferring a pattern to the silicon-containing resist middle layer film by dry-etching while using the resist upper layer film having the pattern as a mask; (I-6) transferring a pattern to the resist underlayer film by dry-etching while using the silicon-containing resist middle layer film having the transferred pattern as a mask;
(I-7) processing the substrate to be processed while using the resist underlayer film having the transferred pattern as a mask to form a pattern in the substrate to be processed;
(I-8) trimming the resist underlayer film having the transferred pattern; and
(I-9) processing the substrate to be processed while using the trimmed resist underlayer film pattern as a mask to form a staircase-shaped pattern in the substrate to be processed, wherein
   the composition for forming a resist underlayer film contains a resin (A) and an organic solvent (B), the resin (A) has a constitutional unit represented by the following general formula (1), and when a phenolic hydroxyl group contained in the resin (A) has a proportion "a" and a group in which a phenolic hydroxyl group is modified has a proportion "b", a relation: a+b=1, 0.1≤a≤0.5, and 0.5≤b≤0.9 is satisfied, 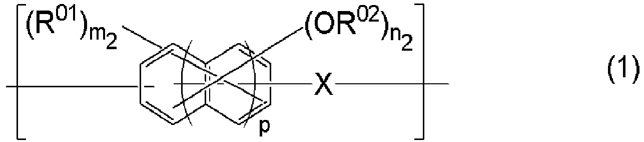
   wherein R⁰¹ represents an optionally substituted saturated or unsaturated monovalent organic group having 1 to 30 carbon atoms; R⁰² represents a hydrogen atom or an optionally substituted saturated or unsaturated monovalent organic group having 1 to 30 carbon atoms; X represents a divalent organic group having 1 to 30 carbon atoms; "p" represents 0 or 1, wherein when "p" is 0, "m₂" represents an integer of 0 to 3, "n₂" represents an integer of 1 to 4, and m₂+n₂ represents an integer of 1 or greater and 4 or smaller, and when "p" is 1, "m₂" represents an integer of 0 to 5, "n₂" represents an integer of 1 to 6, and m₂+n₂ represents an integer of 1 or greater and 6 or smaller.

Hereinafter, the present invention will be described in detail. However, the present invention is not limited thereto.

### <Pattern Forming Method>

The present invention provides a pattern forming method in which a pattern is formed in a substrate to be processed. The pattern forming method includes steps of:
(I-1) applying a composition for forming a resist underlayer film on a substrate to be processed and thereafter performing heat treatment to form a resist underlayer film;
(I-2) forming a silicon-containing resist middle layer film on the resist underlayer film;
(I-3) forming a resist upper layer film by using a photoresist material on the silicon-containing resist middle layer film;
(I-4) performing pattern exposure and subsequent development with a developer in the resist upper layer film to form a pattern in the resist upper layer film; (I-5) transferring a pattern to the silicon-containing resist middle layer film by dry-etching while using the resist upper layer film having the pattern as a mask; (I-6) transferring a pattern to the resist underlayer film by dry-etching while using the silicon-containing resist middle layer film having the transferred pattern as a mask;
(I-7) processing the substrate to be processed while using the resist underlayer film having the transferred pattern as a mask to form a pattern in the substrate to be processed;
(I-8) trimming the resist underlayer film having the transferred pattern; and
(I-9) processing the substrate to be processed while using the trimmed resist underlayer film pattern as a mask to form a staircase-shaped pattern in the substrate to be processed, wherein
   the composition for forming a resist underlayer film contains a resin (A) and an organic solvent (B), the resin (A) has a constitutional unit represented by the following general formula (1), and when a phenolic hydroxyl group contained in the resin (A) has a proportion "a" and a group in which a phenolic hydroxyl group is modified has a proportion "b", a relation: a+b=1, 0.1≤a≤0.5, and 0.5≤b≤0.9 is satisfied, 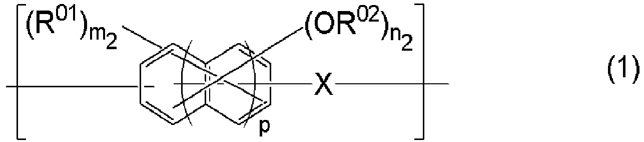
   wherein R⁰¹ represents an optionally substituted saturated or unsaturated monovalent organic group having 1 to 30 carbon atoms; R⁰² represents a hydrogen atom or an optionally substituted saturated or unsaturated monovalent organic group having 1 to 30 carbon atoms; X represents a divalent organic group having 1 to 30 carbon atoms; "p" represents 0 or 1, wherein when "p" is 0, "m₂" represents an integer of 0 to 3, "n₂" represents an integer of 1 to 4, and m₂+n₂ represents an integer of 1 or greater and 4 or smaller, and when "p" is 1, "m₂" represents an integer of 0 to 5, "n₂" represents an integer of 1 to 6, and m₂+n₂ represents an integer of 1 or greater and 6 or smaller.

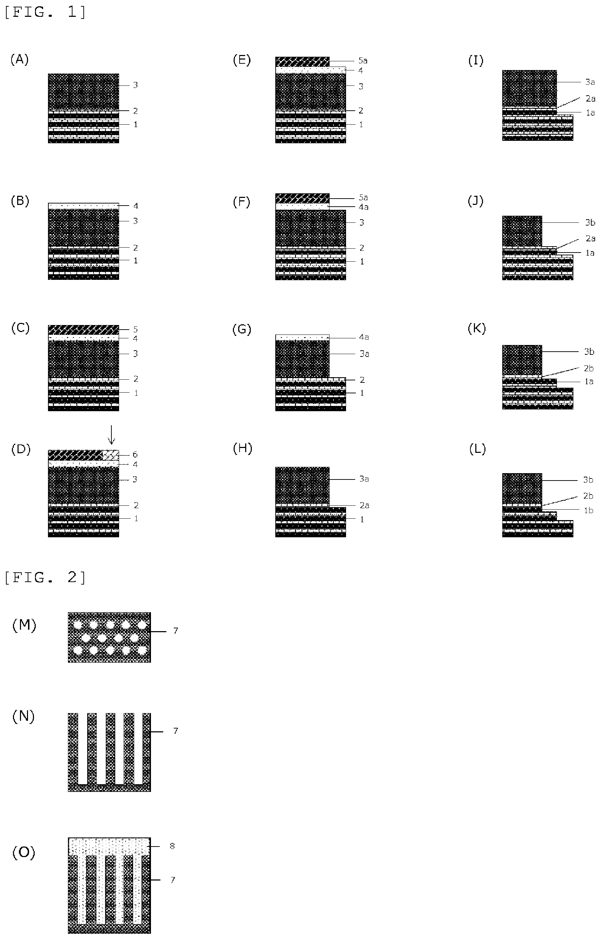

Referring to FIG. 1, a pattern forming method by a three-layer resist process will be described. In the present invention, the following pattern forming method is provided as a pattern forming method by a three-layer resist process using a composition for forming a resist underlayer film. More specifically, as illustrated in FIG. 1(A), a resist underlayer film 3 is formed on a layer 2 to be processed on a substrate 1 to be processed using the composition for forming a resist underlayer film. For example, silicon nitride can be used as the substrate 1 to be processed. For example, silicon oxide can be used as the layer 2 to be processed. Subsequently, as illustrated in FIG. 1(B), a silicon-containing resist middle layer film 4 is formed using a silicon-containing resist middle layer film material on the resist underlayer film 3. Subsequently, as illustrated in FIG. 1(C), a resist upper layer film 5 is formed using a photoresist material on the silicon-containing resist middle layer film 4. Subsequently, an exposed portion 6 of the resist upper layer film is subjected to pattern exposure as illustrated in FIG. 1(D) and development with a developer as illustrated in FIG. 1(E) to form a resist upper layer film pattern 5a in the resist upper layer film. As illustrated in FIG. 1(F), a silicon-containing resist middle layer film pattern 4a is transferred to the silicon-containing resist middle layer film by dry-etching while using the resist upper layer film having the pattern as a mask. As illustrated in FIG. 1(G), a resist underlayer film pattern 3a is transferred to the resist underlayer film by dry-etching while using the silicon-containing resist middle layer film having the transferred pattern as a mask. As illustrated in FIG. 1(H), the layer to be processed on the substrate 1 to be processed is processed while using the resist underlayer film having the pattern as a mask to form a pattern 2a in the layer to be processed. As illustrated in FIG. 1(I), the substrate to be processed is processed while using the layer to be processed having the pattern 2a as a mask to form a pattern 1a. Subsequently, as illustrated in FIG. 1(J), the resist underlayer film pattern is trimmed to form a trimmed resist underlayer film pattern 3b. As illustrated in FIG. 1(K), the pattern formed in the layer to be processed is processed while using the trimmed resist underlayer film pattern 3b as a mask to form a pattern 2b. As illustrated in FIG. 1(L), the substrate to be processed having the pattern is processed by using the layer to be processed having the pattern 2b as a mask to form a pattern 1b. With such a pattern forming method, as illustrated in FIG. 1(L), a staircase-shaped pattern can be formed in the substrate to be processed.

It is preferable that the steps (I-8) to (I-9) are repeated to form a plurality of staircase-shaped patterns in the substrate to be processed.

It is preferable that the substrate to be processed has a structure having multilayer deposition of a polysilicon layer and a silicon oxide (SiO) layer, a silicon oxide (SiO) layer and a silicon nitride (SiN) layer, or polysilicon layers. A structure having multilayer deposition of a silicon oxide (SiO) layer and a silicon nitride (SiN) layer is more preferred. In other words, it is preferable that a multilayer film having stacked polysilicon layers, or a multilayer film having a SiN layer and a SiO layer alternately stacked is used as the substrate to be processed. It is preferable that a multilayer film having a polysilicon layer and a SiO layer alternately stacked, or a multilayer film having a SiN layer and a SiO layer alternately stacked is used as the substrate to be processed. The SiO layer and the SiN layer can be formed by various technologies known in the art, for example, by chemical vapor deposition (CVD) such as plasma enhanced CVD (PECVD) or low-pressure CVD (LPCVD), and atomic layer deposition (ALD).

A substrate having a structure or a step with an aspect ratio of 5 or more may be used as the substrate to be processed.

The pattern forming method of the present invention, which uses a composition for forming a resist underlayer film having high filling property, is useful in particular for microfabrication for a substrate having such a structure or step and is suitable for a process for forming a complicated staircase-shaped pattern.

Since the resist underlayer film in the three-layer resist process exhibits resistance against etching with a fluorine-based gas, it is preferable that dry-etching of the substrate to be processed that is performed using the resist underlayer film as a mask is performed using an etching gas based on a fluorine-based gas in the three-layer resist process.

It is preferable that the resist underlayer film in the three-layer resist process is formed by spin-coating the above composition for forming a resist underlayer film on a substrate to be processed, and subjecting the substrate to be processed having the composition for forming a resist underlayer film applied thereon to heat treatment at a temperature from 100°C to 600°C for 10 to 600 seconds.

It is preferable that the resist underlayer film is formed by spin-coating the above composition for forming a resist underlayer film on a substrate to be processed, and subjecting the substrate to be processed having the composition for forming a resist underlayer film applied thereon to heat treatment in an atmosphere with an oxygen concentration from 1% to 21%. Alternatively, it is preferable that the resist underlayer film is formed by spin-coating the above composition for forming a resist underlayer film on a substrate to be processed, and subjecting the substrate to be processed having the composition for forming a resist underlayer film applied thereon to heat treatment in an atmosphere with an oxygen concentration of less than 1%.

In a method of forming a resist underlayer film in the pattern forming method of the present invention, the substrate to be processed can be coated with the composition for forming a resist underlayer film by using a spin coating method or the like. Good filling property can be achieved by using a spin coating method or the like. After spin coating, baking for accelerating a crosslinking reaction can be performed to evaporate the solvent and prevent mixing with the resist upper layer film or the silicon-containing resist middle layer film. The baking is performed in a temperature range preferably from 100°C to 600°C, more preferably from 100°C to 400°C, and even more preferably from 150°C to 350°C, preferably for 10 to 600 seconds and more preferably for 10 to 300 seconds. The baking temperature and time can be adjusted as appropriate within the above ranges to achieve planarizing and filling properties and curability suitable for the intended use. The baking temperature of 100°C or higher allows curing to proceed well and prevents mixing with the resist upper layer film or the silicon-containing resist middle layer film. The baking temperature of 600°C or lower can suppress thermal decomposition of the resin, prevent reduction of the film thickness, and achieve a uniform film surface.

The atmosphere in baking can be selected as necessary from an oxygen-containing atmosphere such as the air (oxygen concentration of 1% to 21%) and a non-oxygen atmosphere such as nitrogen. For example, when the substrate to be processed is susceptible to air oxidation, damage to the substrate can be suppressed by forming a cured film by heat treatment in an atmosphere with an oxygen concentration of less than 1%.

Since the silicon-containing resist middle layer film in the three-layer resist process exhibits resistance against etching with an oxygen-based gas, in the three-layer resist process, it is preferable that dry-etching of the resist underlayer film using the silicon-containing resist middle layer film as a mask is performed using an etching gas based on an oxygen-based gas.

A polysiloxane-based middle layer film can also be preferably used as the silicon-containing resist middle layer film in the three-layer resist process. Imparting an anti-reflection effect to the silicon-containing resist middle layer film can suppress reflection. In particular, when a material containing a large amount of aromatic groups and having a high etching selectivity to the substrate is used for the resist underlayer film for 193 nm exposure, the k value is higher and the substrate reflection is higher. However, imparting such absorption that achieves an appropriate k value to the silicon-containing resist middle layer film can suppress the reflection so that the substrate reflection can be 0.5% or less. As the silicon-containing resist middle layer film having an anti-reflection effect, it is preferable to use a polysiloxane having a pendant anthracene for 248 nm or 157 nm exposure, or a pendant phenyl group or a pendant light-absorbing group having a silicon-silicon bond for 193 nm exposure, and capable of crosslinking by acid or heat.

In addition, the present invention may be a pattern forming method by a four-layer resist process, which uses an organic anti-reflective film (BARC) or an adhesive film between the silicon-containing resist middle layer film and the resist upper layer film. A pattern forming method may be provided, which involves:
forming a resist underlayer film using the composition for forming a resist underlayer film on a substrate to be processed;
forming a silicon-containing resist middle layer film using a silicon-containing resist middle layer film material on the resist underlayer film;
forming a BARC or an adhesive film on the silicon-containing resist middle layer film;
forming a resist upper layer film using a photoresist material on the BARC or the adhesive film;
performing pattern exposure and subsequent development with a developer in the resist upper layer film to form a pattern in the resist upper layer film;
transferring a pattern to the BARC or the adhesive film and the silicon-containing resist middle layer film by dry-etching while using the resist upper layer film having the pattern as a mask;
transferring a pattern to the resist underlayer film by dry-etching while using the silicon-containing resist middle layer film having the transferred pattern as a mask; and
processing the substrate to be processed while using the resist underlayer film having the transferred pattern as a mask to form a pattern in the substrate to be processed.

Instead of the silicon-containing resist middle layer film, an inorganic hard mask middle layer film may be formed. In this case, a pattern forming method may be provided, which at least involves:
forming a resist underlayer film using the composition for forming a resist underlayer film on a substrate to be processed;
forming an inorganic hard mask middle layer film selected from a silicon oxide film, a silicon nitride film, and a silicon oxynitride film on the resist underlayer film;
forming a resist upper layer film using a photoresist composition on the inorganic hard mask middle layer film to form a circuit pattern in the resist upper layer film;
etching the inorganic hard mask middle layer film while using the resist upper layer film having the pattern as a mask to form a pattern;
etching the resist underlayer film while using the inorganic hard mask middle layer film having the pattern as a mask to form a pattern; and
etching the substrate to be processed while using the resist underlayer film having the pattern as a mask to form a pattern in the substrate to be processed. Such a pattern forming method can form a semiconductor device circuit pattern in the substrate.

As described above, when an inorganic hard mask middle layer film is formed on the resist underlayer film, a silicon oxide film, a silicon nitride film, and a silicon oxynitride film (SiON film) can be formed by a CVD method, an ALD method, or the like. The method of forming a silicon nitride film is disclosed, for example, in JP 2002-334869 A and WO 2004/066377 A1. The film thickness of the inorganic hard mask middle layer film is preferably 5 to 200 nm and more preferably 10 to 100 nm. A SiON film which is effective as an anti-reflective film is most preferably used as the inorganic hard mask middle layer film. Since the substrate temperature is 300 to 500°C during formation of a SiON film, the resist underlayer film needs to withstand temperatures of 300 to 500°C. Since the composition for forming a resist underlayer film used in the present invention has high heat resistance and can withstand high temperatures of 300°C to 500°C, it is possible to combine an inorganic hard mask middle layer film formed by a CVD method or an ALD method with a resist underlayer film formed by spin coating. Alternatively, an inorganic hard mask middle layer may be formed by spin-coating a metal oxide-containing material.

As described above, a photoresist film may be formed as the resist upper layer film on the inorganic hard mask middle layer film. Alternatively, an organic anti-reflective coating (BARC) or an adhesive film may be formed by spin coating on the inorganic hard mask middle layer film, and a photoresist film may be formed on the BARC or the adhesive film. In particular, when a SiON film is used as the inorganic hard mask middle layer film, a two-layer anti-reflective coating including a SiON film and a BARC can suppress reflection even in liquid immersion exposure with a high NA exceeding 1.0. Other advantages of forming a BARC include reducing resist footing of the photoresist pattern immediately above the SiON film.

In the pattern forming method above, the resist upper layer film may be either a positive type or a negative type, and the same photoresist composition as those commonly used can be used. The photoresist composition may include a metal atom such as Sn, In, Ga, Ge, Al, Ce, La, Cs, Zr, Hf, Ti, Bi, Sb, and Zn. When the resist upper layer film is formed using the above photoresist composition, a spin coating method or a vapor deposition process by a CVD method or an ALD method may be employed.

When the photoresist composition is formed by a spin coating method, prebake is performed after applying the photoresist composition, preferably in the range of 60 to 180°C for 10 to 300 seconds. Thereafter, exposure, post-exposure bake (PEB), and development are performed according to the ordinary method to obtain a resist pattern. The thickness of the resist upper layer film is not limited but preferably 10 to 500 nm, particularly preferably 20 to 400 nm.

When the photoresist composition is formed by a vapor deposition process by a CVD method or an ALD method, the photoresist composition is an EUV-sensitive metal oxide-containing film, and the metal is selected from Sn, Zr, Hf, Ti, Bi, Sb, and the like. Among those, Sn which is excellent in EUV sensitivity is preferred. The metal oxide-containing film may be a photosensitive organic metal oxide film such as an organotin oxide (for example, haloalkyl Sn, alkoxyalkyl Sn, or amidoalkyl Sn). Specific examples of an appropriate precursor include trimethyltin chloride, dimethyltin dichloride, methyltin trichloride, tris(dimethylamino)methyltin(IV), and (dimethylamino)trimethyltin(IV).

The metal oxide-containing film may be deposited by PECVD or PEALD, for example, using a Lam Vector (registered trademark) tool. In an ALD example, a Sn oxide precursor is separated from an O precursor/plasma. The deposition temperature is preferably in the range of 50°C to 600°C. The deposition pressure is preferably between 100 and 6,000 mTorr. The flow rate of a precursor solution of the metal oxide-containing film (for example, organotin oxide precursor) may be 0.01 to 10 cmm, and the gas flow rate (CO₂, CO, Ar, N₂) may be 100 to 10,000 sccm. The plasma power may be 200 to 1,000 W per a 300 mm wafer station, using high frequency plasma (for example, 13.56 MHz, 27.1 MHz, or higher frequency). The deposition thickness is preferably 100 to 2,000 Å.

Examples of exposure light include high energy beam with a wavelength of 300 nm or less, specifically, 248 nm, 193 nm, or 157 nm excimer laser beam, 3 to 20 nm soft X-ray, and X-ray.

As a method of forming a circuit pattern in the resist upper layer film, a pattern forming method by photolithography with a wavelength of 5 nm to 300 nm, direct drawing by electron beams, nano-imprinting, or a combination thereof is preferred.

As a development method in the pattern forming method, alkaline development or development by an organic solvent is preferred.

Subsequently, etching is performed using the resulting resist pattern as a mask. The etching of the silicon-containing resist middle layer film or the inorganic hard mask middle layer film in the three-layer resist process is performed by using the upper layer resist pattern as a mask using a fluorocarbon-based gas. Thus, the silicon-containing resist middle layer film pattern or the inorganic hard mask middle layer film pattern are formed.

Subsequently, etching of the resist underlayer film is performed by using the resulting silicon-containing resist middle layer film pattern or the inorganic hard mask middle layer film pattern as a mask. The etching of the resist underlayer film is preferably performed using an etching gas based on an oxygen-based gas.

The subsequent etching of the substrate to be processed can also be performed by an ordinary method. A series of well-controlled process of etching of SiO and SiN and trimming of the resist underlayer film is repeated to form staircase-shaped patterns in the substrate to be processed. FIG. 1(H) illustrates a structure after initial silicon oxide etching, and FIG. 1(I) illustrates a structure after initial silicon nitride etching. After the initial pair of silicon oxide and silicon nitride is removed by etching, the controlled process of trimming the resist underlayer film is performed as illustrated in FIG. 1(J). Subsequently, as illustrated in FIG. 1(K) and (L), first and second series of silicon oxide and silicon nitride etching are performed using the trimmed resist underlayer film. Subsequently, the resist underlayer film is trimmed again, and first, second, and third pairs of silicon oxide/nitride are etched. Subsequently, the controlled trimming of the resist underlayer film is performed again. Appropriate process and chemistry of etching of silicon oxide and silicon nitride and trimming of the resist underlayer film are known in the art, and a dry-etching process is typical. When dry-etching of silicon oxide/nitride is performed by etching based on a fluorocarbon-based gas, the silicon-containing resist middle layer film pattern in the three-layer resist process is stripped simultaneously with the processing of the substrate to be processed.

Since the resist underlayer film used in the pattern forming method of the present invention has excellent etching resistance during etching of the substrate to be processed, a staircase-shaped pattern can be accurately formed in the substrate to be processed.

The number of times the resist underlayer film is trimmed can be controlled, for example, depending on its original thickness and etching selectivity. After the limit of the minimum thickness is reached, the remaining resist underlayer film is typically stripped, and a new resist underlayer film pattern is formed there by using the three-layer resist process. Formation of a staircase-shaped pattern is continued by patterning the new resist underlayer film, etching the oxide layer and the nitride layer, and trimming the resist underlayer film as described above for the original resist underlayer film. This process can be repeated multiple times until formation of desired staircase patterns is completed, typically until the pattern reaches a desired surface of the substrate, typically the silicon surface of the substrate.

The pattern forming method of the present invention is also preferable in terms of productivity, because the resist underlayer film having excellent dry-etching resistance over conventional KrF resists is used, and therefore more staircase patterns can be formed in the substrate to be processed by forming the resist underlayer film once.

In terms of the above, it is preferable that a resist underlayer film having a thickness of at least 3 µm is formed as the resist underlayer film. More specifically, the film thickness of the resist underlayer film is preferably a thickness of at least 3 µm, more preferably a thickness of at least 5 um, even more preferably a thickness of at least 8 um, and particularly preferably a thickness of at least 10 µm.

Forming a resist underlayer film having such a thickness is preferable because more staircase-shaped patterns can be formed in the substrate to be processed.

It is preferable that in the step (I-1), the resist underlayer film is coated to a thickness of at least 3 µm in one application. More specifically, the resist underlayer film is coated preferably to a thickness of at least 3 µm in one application, more preferably a thickness of at least 5 µm, even more preferably a thickness of at least 8 µm, and particularly preferably a thickness of at least 10 µm.

Forming such a thick resist underlayer film in one application is preferable because a process with excellent productivity can be constructed.

In a process using a conventional KrF resist, it is necessary to increase the thickness of the resist in order to improve dry-etching resistance. However, as the thickness increases, the resolution of a resist pattern decreases. On the other hand, in the method using the three-layer resist process in the present invention, the resist underlayer film having excellent dry-etching resistance is used so that the resist upper layer film can be thinned, resulting in resolution of a good resist pattern. More miniaturized patterns can also be formed by using an ArF resist rather than KrF resist.

### <Compound for Forming Resist Underlayer Film>

The composition for forming a resist underlayer film used in the pattern forming method of the present invention contains a resin (A) and an organic solvent (B), the resin (A) has a constitutional unit represented by the following general formula (1), and when a phenolic hydroxyl group contained in the resin (A) has a proportion "a" and a group in which a phenolic hydroxyl group is modified has a proportion "b", a relation: a+b=1, 0.1≤a≤0.5, and 0.5≤b≤0.9 is satisfied, 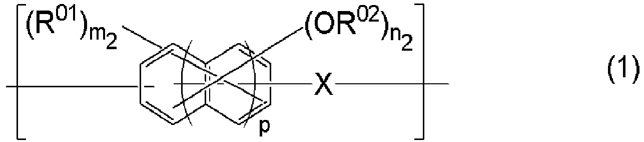 wherein R⁰¹ represents an optionally substituted saturated or unsaturated monovalent organic group having 1 to 30 carbon atoms; R⁰² represents a hydrogen atom or an optionally substituted saturated or unsaturated monovalent organic group having 1 to 30 carbon atoms; X represents a divalent organic group having 1 to 30 carbon atoms; "p" represents 0 or 1, wherein when "p" is 0, "m₂" represents an integer of 0 to 3, "n₂" represents an integer of 1 to 4, and m₂+n₂ represents an integer of 1 or greater and 4 or smaller, and when "p" is 1, "m₂" represents an integer of 0 to 5, "n₂" represents an integer of 1 to 6, and m₂+n₂ represents an integer of 1 or greater and 6 or smaller.

It is preferable that a resin having a weight average molecular weight of 3,000 to 20,000 is used as the resin (A).

In the composition for forming a resist underlayer film, the content of the resin (A) is preferably 20% by mass or more, more preferably 25% by mass or more, and even more preferably 30% by mass or more with respect to the entire composition.

When the composition for forming a resist underlayer film contains the resin (A) in the proportion as described above, a thick resist underlayer film can be formed in one application.

### (A) Resin

The resin (A) has a constitutional unit represented by the general formula (1), and when a phenolic hydroxyl group contained in the resin (A) has a proportion "a" and a group in which a phenolic hydroxyl group is modified contained in the resin (A) has a proportion "b", a relation: a+b=1, 0.1≤a≤0.5, and 0.5≤b≤0.9 is satisfied. It is preferable that the resin (A) contains one of a novolac phenol unit and a novolac naphthol unit.

The resin (A) having such a constitutional unit is preferable because a thick resist underlayer film having excellent dry-etching resistance can be formed.

When the resin (A) is a resin having a constitutional unit represented by the general formula (1), a composition for forming a resist underlayer film with more excellent thermal flowability and substrate affinity can be provided. Furthermore, a thick resist underlayer film having excellent etching resistance can be formed without film formation failures such as cracking.

In the general formula (1), examples of the optionally substituted saturated or unsaturated monovalent organic group having 1 to 30 carbon atoms as represented by R⁰¹ include monovalent saturated hydrocarbon groups such as methyl, ethyl, n-propyl, i-propyl, n-butyl, i-butyl, sec-butyl, tert-butyl, n-pentyl, iso-pentyl, sec-pentyl, and tert-pentyl groups; monovalent unsaturated linear hydrocarbon groups such as ethenyl, propenyl, butenyl, pentenyl, ethynyl, and propynyl groups; monocyclic-type saturated cyclic hydrocarbon groups such as cyclobutyl, cyclopentyl, cyclohexyl, cycloheptyl, and cyclooctyl groups; monovalent monocyclic-type unsaturated cyclic hydrocarbon groups such as cyclobutenyl, cyclopentenyl, and cyclohexenyl groups; monovalent polycyclic-type cyclic hydrocarbon groups such as norbornyl and adamantyl groups; and monovalent aromatic hydrocarbon groups such as phenyl, methylphenyl, naphthyl, methylnaphthyl, anthryl, and methylanthryl groups.

Other examples of the organic group represented by R⁰¹ include alkoxy groups such as methoxy, ethoxy, n-propoxy, i-propoxy, n-butoxy, i-butoxy, sec-butoxy, t-butoxy, n-pentyloxy, and n-hexyloxy groups; and alkoxycarbonyl groups such as methoxycarbonyl, ethoxycarbonyl, n-propoxycarbonyl, i-propoxycarbonyl, n-butoxycarbonyl, i-butoxycarbonyl, sec-butoxycarbonyl, t-butoxycarbonyl, n-pentyloxycarbonyl, and n-hexyloxycarbonyl groups.

Part or all of hydrogen atoms of the above saturated hydrocarbon group, unsaturated linear hydrocarbon group, monocyclic-type saturated cyclic hydrocarbon group, monocyclic-type unsaturated cyclic hydrocarbon group, polycyclic-type cyclic hydrocarbon group, aromatic hydrocarbon group, alkoxy group, and alkoxycarbonyl group may be substituted, and examples of the substituent include halogen atoms such as fluorine, chlorine, bromine, and iodine atoms, hydroxyl group, cyano group, carboxy group, nitro group, amino group, alkoxy group, alkoxycarbonyl group, acyl group, alkoxycarbonyloxy group, aryl group, aliphatic heterocyclic groups such as lactone group, furyl group, and aromatic heterocyclic groups such as pyridyl group.

In terms of filling property and raw material availability, the organic group represented by R⁰¹ is preferably a methyl group.

In the general formula (1), examples of the divalent organic group having 1 to 30 carbon atoms as represented by X include alkanediyl groups such as methylene, ethanediyl, propanediyl, butanediyl, pentanediyl, hexanediyl, octanediyl, and decanediyl groups; monocyclic-type cycloalkanediyl groups such as cyclopropanediyl, cyclobutanediyl, cyclopentanediyl, cyclohexanediyl, cycloheptanediyl, cyclooctanediyl, cyclodecanediyl, methylcyclohexanediyl, and ethylcyclohexanediyl groups; polycyclic-type cycloalkanediyl groups such as bicyclo[2.2.1]heptanediyl, bicyclo[2.2.2]octanediyl, tricyclo[5.2.1.0^{2,5}]decanediyl (dicyclopentylene), tricyclo[3.3.1.1^{3,7}]decanediyl, tetracyclo [6.2.1.1^{1,6}.0^{2,7}] dodecanediyl, and adamantanediyl groups; arenediyl groups such as phenylene and naphthylene groups.

Examples of an alkanediyloxy group represented by X include a group of the alkanediyl group and an oxygen atom in combination. Examples of a cycloalkanediyloxy group represented by X include a group of the cycloalkanediyl group and an oxygen atom in combination.

Part or all of hydrogen atoms of the alkanediyl group, cycloalkanediyl group, alkanediyloxy group, cycloalkanediyloxy group, and arenediyl group may be substituted, and examples of the substituent include the same groups as the examples of the substituent of the organic group represented by R⁰¹.

Examples of the organic group represented by X include groups represented by the following formulae, 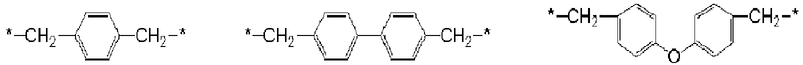 wherein a broken line represents a bonding arm.

In terms of filling property and raw material availability, the organic group represented by X is preferably a methylene group.

In the general formula (1), R⁰² represents a hydrogen atom or an optionally substituted saturated or unsaturated monovalent organic group having 1 to 30 carbon atoms. Examples of a preferable structure of R⁰² include a hydrogen atom, an alkyl group having 1 to 10 carbon atoms, and any one of structures represented by the following general formulae (8), 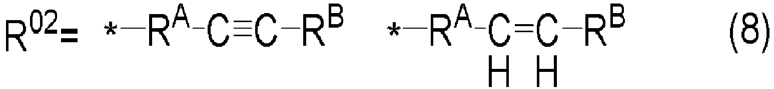 wherein * represents a bonding site with an oxygen atom; R^{A} represents an optionally substituted divalent organic group having 1 to 10 carbon atoms; and R³ represents a hydrogen atom or an optionally substituted monovalent organic group having 1 to 10 carbon atoms.

In the general formulae (8), examples of the divalent organic group having 1 to 10 carbon atoms as represented by R^{A} include alkanediyl groups such as methylene, ethanediyl, propanediyl, butanediyl, pentanediyl, hexanediyl, octanediyl, and decanediyl groups, and arenediyl groups such as benzenediyl, methylbenzenediyl, and naphthalenediyl groups.

In the general formulae (8), examples of the monovalent organic group having 1 to 10 carbon atoms as represented by R^{B} include alkyl groups such as methyl, ethyl, n-propyl, i-propyl, n-butyl, i-butyl, sec-butyl, t-butyl, n-pentyl, n-hexyl, n-octyl, and n-decyl groups; and aryl groups such as phenyl, tolyl, xylyl, mesityl, and naphthyl groups.

Part or all of hydrogen atoms of the alkanediyl group, arenediyl group, alkyl group, and aryl group may be substituted, and examples of the substituent include the same groups as the examples of the substituent of the organic group represented by R⁰¹.

Particularly preferable examples can include structures represented by the following. Having such a structure provides good flowability and improves filling property and planarizing property. Further, such a structure provides good heat resistance and film formability and can suppress sublimates during heat curing, suppress contamination of the apparatus due to sublimates, and suppress coating defects, 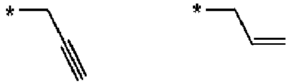 wherein * represents a bonding site with an oxygen atom.

Examples of the structure represented by the proportion "b" in the resin having a structural unit represented by the general formula (1) include, but not limited to, the following.

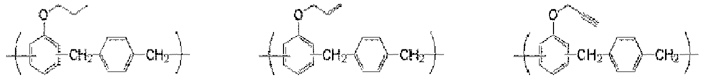

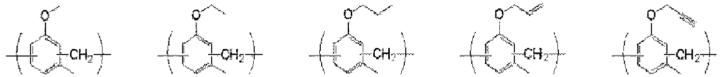

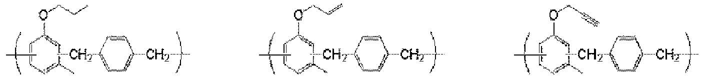

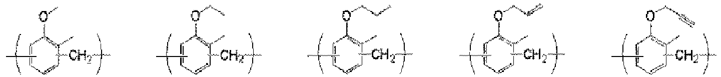

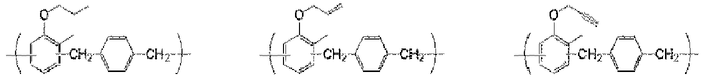

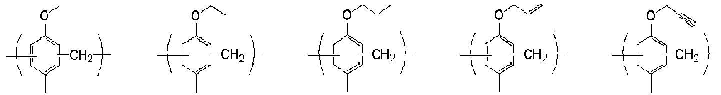

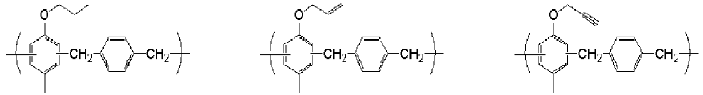

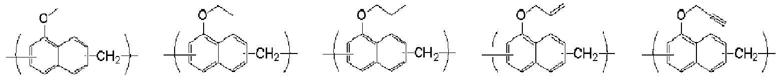

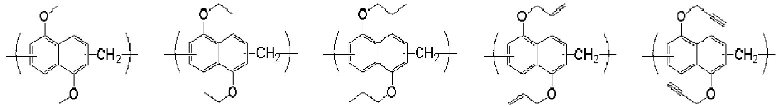

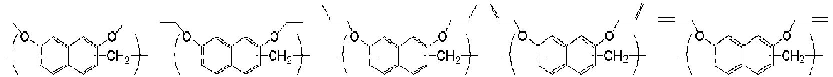

Furthermore, in the resin (A), when a phenolic hydroxyl group has a proportion "a" and a group in which a phenolic hydroxyl group is modified has a proportion "b", a+b satisfies a relation: a+b=1, 0.1≤a≤0.5, and 0.5≤b≤0.9. Preferably, the relation between a and b is a+b=1, 0.15≤a≤0.4, and 0.6≤b≤0.85. When the proportion "b" is less than 0.5, the contribution of hydrogen bonds of the phenolic hydroxyl group is high and the complex viscosity of the resin increases. Thus, there are concerns that lower flowability is exhibited and the filling property is deteriorated. When the proportion "b" exceeds 0.9, the proportion of the phenolic hydroxyl group in the resin is low, and there is a concern that the adhesion to the substrate to be processed is deteriorated.

In the general formula (1), "p" represents 0 or 1. When "p" is 0, "m₂" represents an integer of 0 to 3, "n₂" represents an integer of 1 to 4, and m₂+n₂ represents an integer of 1 or greater and 4 or smaller. When "p" is 1, "m₂" represents an integer of 0 to 5, "n₂" represents an integer of 1 to 6, and m₂+n₂ represents an integer of 1 or greater and 6 or smaller.

The resin (A) used in the composition for forming a resist underlayer film preferably has a weight average molecular weight of 3,000 to 20,000. The weight average molecular weight (Mw) is based on a value measured by gel permeation chromatography (tetrahydrofuran solvent, polystyrene standard). The resin (A) has a weight average molecular weight of preferably 3,000 to 20,000, more preferably 3,500 to 15,000, and even more preferably 4,000 to 10,000. A weight average molecular weight of 3,000 or more prevents contamination of the apparatus due to increase in sublimate during film baking. On the other hand, a weight average molecular weight of 20,000 or less provides sufficient thermal flowability and thus can impart excellent film forming property and filling property. Adjusting the molecular weight of the resin in a proper range in this way can achieve the balance between competing properties: deterioration in film forming property and filling property due to reduced thermal flowability caused by increasing the molecular weight of the resin; and increase in sublimates and deterioration in film thickness uniformity due to low molecular components in the resin caused by decreasing the molecular weight.

Further, the ratio Mw/Mn of the weight average molecular weight Mw to the number average molecular weight Mn in terms of polystyrene standard by gel permeation chromatography of the resin (A) is preferably 2.00≤Mw/Mn≤5.00 and more preferably 2.50≤Mw/Mn≤4.00. Mw/Mn of 5.00 or less prevents contamination of the apparatus due to increase in sublimate during film baking. On the other hand, Mw/Mn of 2.00 or more provides sufficient thermal flowability because of the inclusion of a low molecular weight component and thus can impart excellent filling property. Adjusting the ratio Mw/Mn of the weight average molecular weight Mw to the number average molecular weight Mn of the resin in such a proper range can achieve the balance between competing properties: deterioration in film forming property and filling property due to reduced thermal flowability caused by monodispersity of the resin; and increase in sublimates and deterioration in film thickness uniformity due to a low molecular component in the resin caused by polydispersity.

In present invention, the resin (A) may be used singly or in mixture of two or more. Alternatively, a resin that does not contain the structural unit represented by the general formula (1) may be mixed. In this case, the resin that may be mixed is not limited, and known resins can be used. Specifically, acrylic resins, styrene resins, phenolic resins, polyether resins, and epoxy resins are preferred. Preferably, these resins are mixed depending on the purpose.

In the pattern forming method of the present invention, another compound or polymer may be blended in the composition for forming a resist underlayer film, depending on the purpose. The compound for blending or the polymer for blending is mixed with the resin having a structural unit represented by the general formula (1) and serves to improve the film formability in spin coating and the filling property in a stepped substrate. The compound for blending or the polymer for blending is preferably a compound having a phenolic hydroxyl group.

Examples of such a material include novolac resins derived from phenol, o-cresol, m-cresol, p-cresol, 2,3-dimethylphenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-tert-butylphenol, 3-tert-butylphenol, 4-tert-butylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, 4-tert-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-tert-butyl-5-methylphenol, pyrogallol, thymol, isothymol, 4,4'-(9H-fluoren-9-ylidene)bisphenol, 2,2'-dimethyl-4,4'-(9H-fluoren-9-ylidene)bisphenol, 2,2'-diallyl-4,4'-(9H-fluoren-9-ylidene)bisphenol, 2,2'-difluoro-4,4'-(9H-fluoren-9-ylidene)bisphenol, 2,2'-diphenyl-4,4'-(9H-fluoren-9-ylidene)bisphenol, 2,2'-dimethoxy-4,4'-(9H-fluoren-9-ylidene)bisphenol, 2,3,2',3'-tetrahydro-(1,1')-spirobiindene-6,6'-diol, 3,3,3',3'-tetramethyl-2,3,2',3'-tetrahydro-(1,1')-spirobiindene-6,6'-diol, 3,3,3',3',4,4'-hexamethyl-2,3,2',3'-tetrahydro-(1,1')-spirobiindene-6,6'-diol, 2,3,2',3'-tetrahydro-(1,1')-spirobiindene-5,5'-diol, 5,5'-dimethyl-3,3,3',3'-tetramethyl-2,3,2',3'-tetrahydro-(1,1')-spirobiindene-6,6'-diol, 1-naphthol, 2-naphthol, 2-methyl-1-naphthol, 4-methoxy-1-naphthol, 7-methoxy-2-naphthol, and dihydroxynaphthalenes such as 1,5-dihydroxynaphthalene, 1,7-dihydroxynaphthalene and 2,6-dihydroxynaphthalene, methyl 3-hydroxynaphthalene-2-carboxylate, indene, hydroxyindene, benzofuran, hydroxyanthracene, acenaphthylene, biphenyl, bisphenol, trisphenol, dicyclopentadiene, tetrahydroindene, 4-vinylcyclohexene, norbornadiene, 5-vinylnorbornan-2-ene, α-pinene, β-pinene, limonene, and the like; and polyhydroxystyrene, polystyrene, polyvinyl naphthalene, polyvinyl anthracene, polyvinyl carbazole, polyindene, polyacenaphthylene, polynorbornene, polycyclodecene, polytetracyclododecene, polynortricyclene, poly(meth)acrylate, and copolymers thereof. Other examples of the material that can be blended include naphthol dicyclopentadiene copolymers described in JP 2004-205685 A, fluorene bisphenol novolac resins described in JP 2005-128509 A, acenaphthylene copolymers described in JP 2005-250434 A, fullerenes having phenol groups described in JP 2006-227391 A, bisphenol compounds and novolac resins thereof described in JP 2006-293298 A, adamantane phenol compounds and novolac resins thereof described in JP 2006-285095 A, bisnaphthol compounds and novolac resins thereof described in JP 2010-122656 A, and fullerene resin compounds described in JP 2008-158002 A.

### (B) Organic Solvent

The organic solvent (B) that can be used in the composition for forming a resist underlayer film used in the pattern forming method of the present invention is not limited as long as it can dissolve or disperse the resin (A). It is preferable that the organic solvent (B) can also dissolve or disperse a base generator (C), a crosslinking agent (D), a flowability accelerator (E), a surfactant (F), and a plasticizer (G) which will be described later.

Specifically, the organic solvent disclosed in paragraphs [0091] to [0092] in JP 2007-199653 A can be added. More specifically, propylene glycol monomethyl ether acetate, propylene glycol monomethyl ether, propylene glycol monoethyl ether, propylene glycol monopropyl ether, 2-heptanone, cyclopentanone, cyclohexanone, and γ-butyrolactone, or a mixture containing one or more of these is preferably used.

The amount of the organic solvent (B) blended is preferably adjusted according the set film thickness of the resist underlayer film. Typically, the amount of the organic solvent (B) is preferably in the range of 100 to 50,000 parts by mass with respect to 100 parts by mass of the resin (A), more preferably 100 to 400 parts by mass in order to form a thick resist underlayer film, even more preferably 100 to 300 parts by mass, particularly preferably 100 to 250 parts by mass, and most preferably 100 to 200 parts by mass. Such an amount of the organic solvent blended enables formation of a thicker resist underlayer film and more suitable use of the composition for forming a resist underlayer film with excellent filling property and substrate adhesion.

### (C) Base Generator

The composition for forming a resist underlayer film used in the pattern forming method of the present invention can contain a base generator (C) to form a resist underlayer film having good adhesion to the substrate to be processed, without any inconvenience such as substrate separation during dry-etching, for example, even when a thick resist underlayer film is formed. It is preferable that an acid generator is not involved in order to maximize the effect of the base generator.

In the present invention, the base generator refers to the one having its chemical structure changed by external stimulus such as light and heat to generate a base, and is also called "latent base" or "base precursor". The base generated may be not only a common base such as ammonia or amine but also a chemical species having the function of enhancing ionicity of the phenolic hydroxyl group in the resin (A).

The component (C) base generator is not limited, and a known base generator can be used. The base generator (C) is preferably a compound that expresses basicity by thermal decomposition, because film formation using the composition for forming a resist underlayer film involves heating, and the interaction of the phenolic hydroxyl group in the resin (A) having ionicity with the substrate is expected to increase during heating and thereby improve the film formability. The composition for forming a resist underlayer film containing such a component (C) can achieve both of the thermal flowability of the film and the interaction with the substrate by adjusting the amount of component (C) added.

When such a base generator that expresses basicity by thermal decomposition (also referred to as thermal base generator) is used as the component (C), the generated base is the excessive cation in the system due to evaporation or decomposition of the anion. Specific examples include triphenylsulfonium cation and tetrabutylammonium cation. These base generators increase the ionicity (polarity) of the phenolic hydroxyl group in the resin (A), and even on a substrate hydrophobized, for example, treated with HMDS, the phenolic hydroxyl group interacts with the polar group such as silanol group present in the surface of the substrate to improve the adhesion of the composition for forming a resist underlayer film to the substrate. On the other hand, since the action as described above does not take place before heating, that is, before base generation, the flowability of the composition for forming a resist underlayer film itself is maintained. In this way, a resist underlayer film having excellent film formability can be formed.

It is more preferable that any one represented by the following general formulae (2), (3), and (4) is used as the base generator (C), 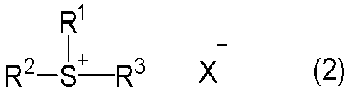 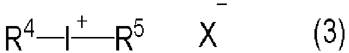 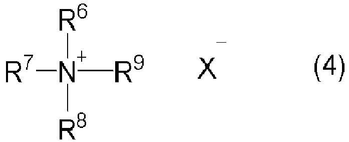 wherein R¹ to R³ each independently represent a linear, branched, or cyclic alkyl group having 1 to 10 carbon atoms or alkenyl group having 2 to 10 carbon atoms, which may be substituted with or separated by a hetero atom, or represent an aryl group having 6 to 18 carbon atoms or aralkyl group having 7 to 18 carbon atoms, which may be substituted with or separated by a hetero atom; any two of R¹, R², and R³ may bond together to form a ring with a sulfur atom in the formula; X⁻represents an organic or inorganic anion serving as a pairing ion, provided that X⁻ does not include OH⁻; R⁴ and R⁵ are each independently an aryl group having 6 to 20 carbon atoms, which may be substituted with or separated by a hetero atom, in which part or all of hydrogen atoms may be substituted with a linear, branched, or cyclic alkyl group or alkoxy group having 1 to 10 carbon atoms; R⁴ and R⁵ may bond together to form a ring with an iodine atom in the formula; R⁶, R⁷, R⁸, and R⁹ each independently represent a hydrogen atom, or a linear, branched, or cyclic alkyl group having 1 to 20 carbon atoms or alkenyl group having 2 to 20 carbon atoms, which may be substituted with or separated by a hetero atom, or represent an aryl group having 6 to 18 carbon atoms or aralkyl group having 7 to 18 carbon atoms, which may be substituted with or separated by a hetero atom; and any two or more of R⁶, R⁷, R⁸, and R⁹ may bond together to form a ring with a nitrogen atom in the formula.

Specific examples of R¹, R², and R³ in the general formula (2) include alkyl groups such as methyl, ethyl, n-propyl, isopropyl, n-butyl, tert-butyl, cyclopropyl, cyclopenthyl, cyclohexyl, cyclopropylmethyl, 4-methylcyclohexyl, cyclohexylmethyl, norbornyl, and adamantyl groups; alkenyl groups such as vinyl, allyl, propenyl, butenyl, hexenyl, and cyclohexenyl groups; aryl groups such as phenyl, naphthyl, and thienyl groups; and aralkyl groups such as benzyl, 1-phenylethyl, and 2-phenylethyl groups. Aryl groups are preferred. Part of hydrogen atoms in these groups may be substituted with a hetero atom such as oxygen, sulfur, nitrogen, and halogen atoms or may be separated by a hetero atom such as oxygen, sulfur, and nitrogen atoms, and as a result, a hydroxyl group, cyano group, carbonyl group, ether bond, ester bond, sulfonic acid ester bond, carbonate bond, lactone ring, sultone ring, carboxylic anhydride, haloalkyl group or the like may form or intervene.

When any two of R¹, R², and R³ bond together directly or through an oxygen atom, methylene group, sulfone group, or carbonyl group, examples include, but not limited to, dibenzothiophene skeleton, phenoxathiin skeleton, and partial structures illustrated below. In the following formulae, the structure may have a substituent at any position on an aromatic ring.

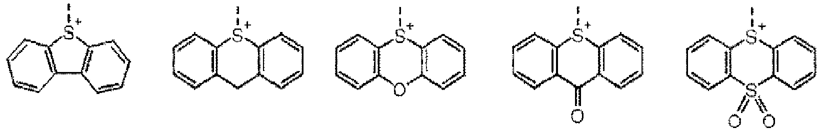

More specifically, examples of sulfonium cation include triphenylsulfonium, 4-hydroxyphenyldiphenylsulfonium, bis(4-hydroxyphenyl)phenylsulfonium, tris(4-hydroxyphenyl)sulfonium, 4-tert-butoxyphenyldiphenylsulfonium, bis(4-tert-butoxyphenyl)phenylsulfonium, tris(4-tert-butoxyphenyl)sulfonium, 3-tert-butoxyphenyldiphenylsulfonium, bis(3-tert-butoxyphenyl)phenylsulfonium, tris(3-tert-butoxyphenyl)sulfonium, 4-tert-butylphenyldiphenylsulfonium, tris(4-tert-butylphenyl)sulfonium, 3,4-di-tert-butoxyphenyldiphenylsulfonium, bis(3,4-di-tert-butoxyphenyl)phenylsulfonium, tris(3,4-di-tert-butoxyphenyl)sulfonium, diphenyl(4-thiophenoxyphenyl)sulfonium, 10-phenylphenoxathiinium, S-phenyldibenzothiophenium, 4-tert-butoxycarbonylmethyloxyphenyldiphenylsulfonium, tris(4-tert-butoxycarbonylmethyloxyphenyl)sulfonium, (4-tert-butoxyphenyl)bis(4-dimethylaminophenyl)sulfonium, tris(4-dimethylaminophenyl)sulfonium, 2-naphthyldiphenylsulfonium, (4-hydroxy-3,5-dimethylphenyl)diphenylsulfonium, and (4-n-hexyloxy-3,5-dimethylphenyl)diphenylsulfonium. Other examples include 4-methacryloyloxyphenyldiphenylsulfonium, 4-acryloyloxyphenyldiphenylsulfonium, 4-methacryloyloxyphenyldimethylsulfonium, 4-acryloyloxyphenyldimethylsulfonium, (4-methacryloyloxy-3,5-dimethylphenyl)diphenylsulfonium, and (4-acryloyloxy-3,5-dimethylphenyl)diphenylsulfonium. More preferable examples include triphenylsulfonium, 4-tert-butylphenyldiphenylsulfonium, 4-tert-butoxyphenyldiphenylsulfonium, 10-phenylphenoxathiinium, and S-phenyldibenzothiophenium. Among those, triphenylsulfonium, 4-tert-butylphenyldiphenylsulfonium, and 4-tert-butoxyphenyldiphenylsulfonium are more preferable.

Specific examples of R⁴ and R⁵ in the general formula (3) include, but not limited to, phenyl, naphthyl, with any substitution position of the substituent, tolyl, xylyl, trimethylphenyl, ethylphenyl, isopropylphenyl, tert-butylphenyl, 1-adamantylphenyl, triisopropylphenyl, tricyclohexylphenyl, methoxyphenyl, ethoxyphenyl, butoxyphenyl, hydroxyphenyl, dihydroxyphenyl, trimethoxyphenyl, methylthiophenyl, biphenyl, fluorophenyl, difluorophenyl, bromophenyl, iodophenyl, N,N-diphenylaminophenyl, acetoxyphenyl, acetylaminophenyl, 2,2,2-trifluoroethoxyphenyl, (2-methoxyethoxy)phenyl, hydroxynaphthyl, dihydroxynaphthyl, 2,2,2-trifluoroethoxynaphthyl, and (2-methoxyethoxy)naphthyl groups.

R⁴ and R⁵ are preferably a non-substituted phenyl group, or a phenyl group having a substituent selected from a halogen atom, an alkyl group, and an alkoxy group at the para position to the iodine atom. In particular, a phenyl group, a 4-tert-butylphenyl group, a 4-fluorophenyl group, and the like are preferable.

When R⁴ and R⁵ bond together directly or through an oxygen atom, methylene group, sulfone group, or carbonyl group, examples include, but not limited to, partial structures illustrated below. In the following formulae, the structure may have a substituent at any position on an aromatic ring.

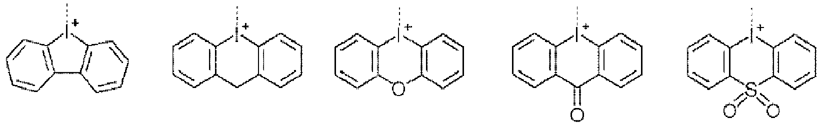

More specifically, examples of iodonium cation include, but not limited to, the following. In the following formulae, tBu is a tert-butyl group, and Ph is a phenyl group.

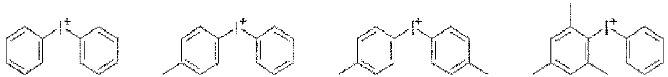

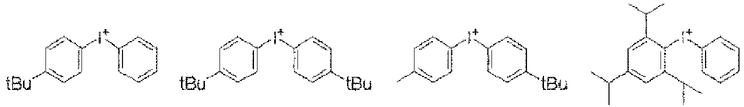

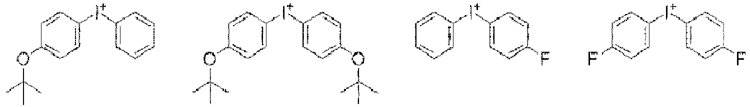

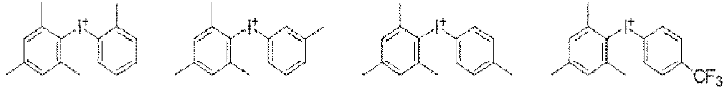

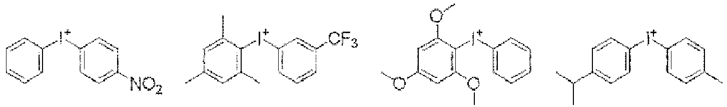

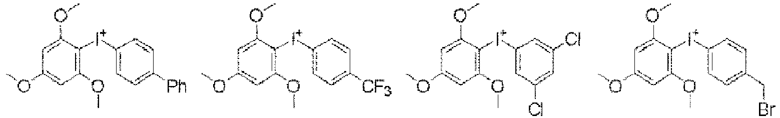

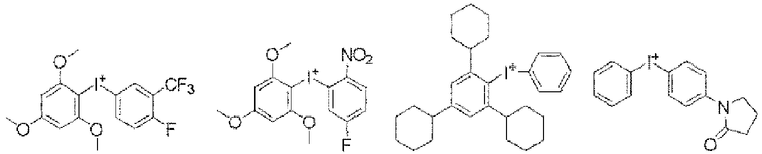

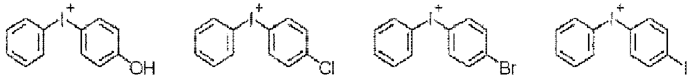

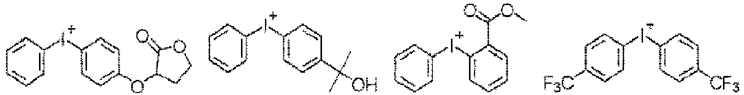

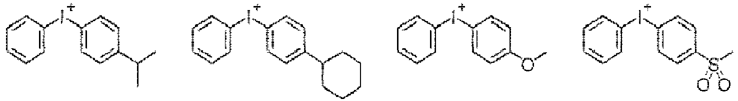

Examples of ammonium cation represented by the general formula (4) include ammonium cations resulting from protonation of the nitrogen atom of the following compounds: ammonia, primary, secondary and tertiary aliphatic amines, mixed amines, aromatic amines, heterocyclic amines, nitrogen-containing compounds having carboxy group, nitrogen-containing compounds having sulfonyl group, nitrogen-containing compounds having hydroxyl group, nitrogen-containing compounds having hydroxyphenyl group, and alcoholic nitrogen-containing compounds, as well as quaternary ammonium cations.

Specifically, examples of the primary aliphatic amines include methylammonium, ethylammonium, n-propylammonium, isopropylammonium, n-butylammonium, isobutylammonium, sec-butylammonium, tert-butylammonium, pentylammonium, tert-amylammonium, cyclopentylammonium, hexylammonium, cyclohexylammonium, heptylammonium, octylammonium, nonylammonium, decylammonium, dodecylammonium, cetylammonium, aminomethylammonium, and 2-aminoethylammonium. Examples of the secondary aliphatic amines include dimethylammonium, diethylammonium, di-n-propylammonium, diisopropylammonium, di-n-butylammonium, diisobutylammonium, di-sec-butylammonium, dipentylammonium, dicyclopentylammonium, dihexylammonium, dicyclohexylammonium, diheptylammonium, dioctylammonium, dinonylammonium, didecylammonium, didodecylammonium, dicetylammonium, methyl(methylamino)methylammonium, and methyl-2-(methylamino)ethylammonium. Examples of the tertiary aliphatic amines include trimethylammonium, triethylammonium, tri-n-propylammonium, triisopropylammonium, tri-n-butylammonium, triisobutylammonium, tri-sec-butylammonium, tripentylammonium, tricyclopentylammonium, trihexylammonium, tricyclohexylammonium, triheptylammonium, trioctylammonium, trinonylammonium, tridecylammonium, tridodecylammonium, tricetylammonium, dimethyl(dimethylamino)methylammonium, and dimethyl(2-dimethylaminoethyl)ammonium.

Examples of the mixed ammines include dimethyl ethyl ammonium, methyl propyl ammonium, benzyl ammonium, phenethyl ammonium, and benzyl dimethyl ammonium. Specific examples of the aromatic amines and heterocyclic ammines include anilinium derivatives (for example, anilinium, N-methylanilinium, N-ethylanilinium, N-propylanilinium, N,N-dimethylanilinium, 2-methylanilinium, 3-methylanilinium, 4-methylanilinium, ethylanilinium with an arbitrary substitution position, propylanilinium with an arbitrary substitution position, trimethylanilinium with an arbitrary substitution position, 2-nitroanilinium, 3-nitroanilinium, 4-nitroanilinium, 2,4-dinitroanilinium, 2,6-dinitroanilinium, 3,5-dinitroanilinium, and N,N-dimethyltoluidinium with an arbitrary substitution position), diphenyl(p-tolyl)ammonium, methyldiphenylammonium, triphenylammonium, aminophenylammonium with an arbitrary substitution position, naphthylammonium, aminonaphthylammonium with an arbitrary substitution position, pyrrolinium derivatives (for example, pyrrolinium, 2H-pyrrolinium, 1-methylpyrrolinium, 2,4-dimethylpyrrolinium, 2,5-dimethylpyrrolinium, and N-methylpyrrolinium), oxazolium derivatives (for example, oxazolium and isooxazolium), thiazolium derivatives (for example, thiazolium and isothiazolium), imidazolium derivatives (for example, imidazolium, 4-methylimidazolium, and 4-methyl-2-phenylimidazolium), pyrazolium derivatives, furazanium derivatives, 2-methyl-1-pyrrolinium, pyrrolidinium derivatives (for example, pyrrolidinium, N-methylpyrrolidinium, pyrrolidinonium, and N-methylpyrolidonium), imidazolinium derivatives, imidazolidinium derivatives, pyridinium derivatives (for example, pyridinium, methylpyridinium, ethylpyridinium, propylpyridinium, butylpyridinium, 4-(1-butylpentyl)pyridinium, dimethylpyridinium, trimethylpyridinium, triethylpyridinium, phenylpyridinium, 3-methyl-2-phenylpyridinium, 4-tert-butylpyridinium, diphenylpyridinium, benzylpyridinium, methoxypyridinium, butoxypyridinium, dimethoxypyridinium, 4-pyrrolidinopyridinium, 2-(1-ethylpropyl)pyridinium, aminopyridinium, and dimethylaminopyridinium), pyridazinium derivatives, pyrimidinium derivatives, pyrazinium derivatives, pyrazolinium derivatives, pyrazolidinium derivatives, piperidinium derivatives, piperazinium derivatives, molpholinium derivatives, indolinium derivatives, isoindolinium derivatives, 1H-indazolinium derivatives, qunolinium derivatives (for example, quinolinium), isoquinolinium derivatives, cinnolinium derivatives, quinazolinium derivatives, quinoxalinium derivatives, phthalazinium derivatives, purinium derivatives, pteridinium derivatives, carbazolium derivatives, phenanthridinium derivatives, acridinium derivatives, phenazinium derivatives, and 1,10-phenanthrolinium derivatives.

Examples of the nitrogen-containing compounds having carboxy group include carboxyphenylammonium, carboxyindolinium, and amino acid derivatives (for example, protonated forms of nicotinic acid, alanine, alginine, aspartic acid, glutamic acid, glycine, histidine, isoleucine, glycylleucine, leucine, methionine, phenylalanine, threonine, lysine, 3-aminopyrazine-2-carboxylic acid, and methoxyalanine). Examples of the nitrogen-containing compounds having sulfonyl group include 3-pyridiniumsulfonic acid. Examples of the nitrogen-containing compounds having hydroxyl group, nitrogen-containing compounds having hydroxyphenyl group, and alcoholic nitrogen-containing compounds include 2-hydroxypyridinium, hydroxyanilinium with an arbitrary substitution position, hydroxy-methylanilinium with an arbitrary substitution position, hydroxyquinolinium, dihydroxyquinolinium, 2-hydroxyethylammonium, bis(2-hydroxyethyl)ammonium, tris(2-hydroxyethyl)ammonium, ethylbis(2-hydroxyethyl)ammonium, diethyl(2-hydroxyethyl)ammonium, hydroxypropylammonium, bis(hydroxypropyl)ammonium, tris hydroxypropyl)ammonium, 4-(2-hydroxyethyl)morpholinium, 2-(2-hydroxyethyl)pyridinium, 1-(2-hydroxyethyl)piperazinium, 1-[2-(2-hydroxyethoxy)ethyl]piperazinium, (2-hydroxyethyl)piperazinium, 1-(2-hydroxyethyl)pyrrolidinium, 1-(2-hydroxyethyl)-2-pyrrolidinonium, 2,3-dihydroxypropylpiperidinium, 2,3-dihydroxypropylpiperolidinium, 8-hydroxyjulolidinium, and 3-hydroxyquinuclidinium.

Specific examples of the quaternary ammonium salts include tetramethylammonium, triethylmethylammonium, tetraethylammonium, tetrabutylammonium, tetraoctylammonium, didecyldimethylammonium, tridecylmethylammonium, hexadecyltrimethylammonium, stearyltrimethylammonium, benzyltrimethylammonium, benzyltriethylammonium, benzyltributylammonium, and 2-hydroxyethyltrimethylammonium.

The ammonium cation is preferably quaternary ammonium cation, particularly preferably tetramethylammonium cation, tetraethylammonium cation, and tetrabutylammonium cation.

Here, it is more preferable that one of: a structure represented by any one of the following general formulae (5), (6), and (7); and an anion selected from the group consisting of chloride ion, bromide ion, iodide ion, fluoride ion, cyanide ion, nitrate ion, and nitrite ion is used as X⁻ in the general formulae (2), (3), and (4),

R¹⁰-COO⁻ (5)

R¹¹-SO₃⁻ (6)

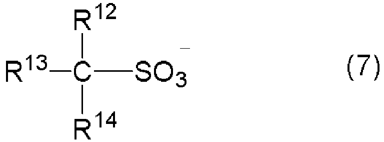

wherein R¹⁰ represents a linear, branched, or cyclic alkyl group having 1 to 20 carbon atoms, alkenyl group having 2 to 20 carbon atoms, aryl group having 6 to 20 carbon atoms, or aralkyl group having 7 to 20 carbon atoms, which may contain one or more selected from an ether group, an ester group, and a carbonyl group, and part or all of hydrogen atoms in these groups may be substituted with one or more selected from a halogen atom, a hydroxyl group, a carboxy group, an amino group, and a cyano group; R¹¹ represents an aryl group having 6 to 20 carbon atoms, and part or all of hydrogen atoms in the aryl group may be substituted with one or more selected from a halogen atom, a hydroxyl group, a carboxy group, an amino group, and a cyano group; R¹², R¹³, and R¹⁴ each independently represent a hydrogen atom, a halogen atom except fluorine atom, or a linear, branched, or cyclic alkyl group having 1 to 20 carbon atoms, alkenyl group having 2 to 20 carbon atoms, aryl group having 6 to 20 carbon atoms, or aralkyl group having 7 to 20 carbon atoms, which may contain one or more selected from an ether group, an ester group, and a carbonyl group, and part or all of hydrogen atoms in these groups may be substituted with one or more selected from a halogen atom, a hydroxyl group, a carboxy group, an amino group, and a cyano group; and two or more of R¹², R¹³, and R¹⁴ may bond together to form a ring.

Examples of carboxylate anion represented by the general formula (5) include formate, acetate, propionate, butyrate, isobutyrate, valerate, isovalerate, pivalate, hexanoate, octanoate, cyclohexanecarboxylate, cyclohexylacetate, laurate, myristate, palmitate, stearate, phenylacetate, diphenylacetate, phenoxyacetate, mandelate, benzoylformate, cinnamate, dihydrocinnamate, benzoate, methylbenzoate, salicylate, naphthalenecarboxylate, anthracenecarboxylate, anthraquinonecarboxylate, hydroxyacetate, pivalate, lactate, methoxyacetate, 2-(2-methoxyethoxy)acetate, 2-(2-(2-methoxyethoxy)ethoxy)acetate, diphenolate, monochloroacetate, dichloroacetate, trichloroacetate, trifluoroacetate, pentafluoropropionate, heptafluorobutyrate, and 2-hydroxy-2,2-bis(trifluoromethyl)acetate anions. Other examples include mono-anions of dicarboxylic acids such as succinic acid, tartaric acid, glutaric acid, pimelic acid, sebacic acid, phthalic acid, isophthalic acid, terephthalic acid, naphthalenedicarboxylic acid, cyclohexanedicarboxylic acid, and cyclohexenedicarboxylic acid.

Specific examples of arenesulfonate anion represented by the general formula (6) include benzenesulfonate, 4-toluenesulfonate, 2-toluenesulfonate, xylenesulfonate with an arbitrary substitution position, trimethylbenzenesulfonate, mesitylenesulfonate, 4-methoxybenzenesulfonate, 4-ethylbenzenesulfonate, 2,4,6-triisopropylbenzenesulfonate, 1-naphthalenesulfonate, 2-naphthalenesulfonate, anthraquinone-1-sulfonate, anthraquinone-2-sulfonate, 4-(4-methylbenzenesulfonyloxy)benzenesulfonate, 3,4-bis(4-methylbenzenesulfonyloxy)benzenesulfonate, 6-(4-methylbenzenesulfonyloxy)naphthalene-2-sulfonate, 4-phenyloxybenzenesulfonate, 4-diphenylmethylbenzenesulfonate, 2,4-dinitrobenzenesulfonate, and dodecylbenzenesulfonate.

Specific examples of alkanesulfonate anion represented by the general formula (7) include methanesulfonate, ethanesulfonate, propanesulfonate, butanesulfonate, pentanesulfonate, hexanesulfonate, cyclohexanesulfonate, octanesulfonate, and 10-camhporsulfonate.

Further, it is more preferable that a conjugate acid X-H of X⁻ in the general formulae (2), (3), and (4) has a boiling point of 200°C or lower. As used herein the boiling point is a value at one atmosphere (1013 hPa) .

X⁻ in the general formulae (2), (3), and (4) is particularly preferably trifluoroacetate anion, pentafluoropropionate anion, 2-hydroxy-2,2-bis(trifluoromethyl)acetate anion, chloride ion, or nitrate ion.

Examples of the base generator (C) include, but not limited to, any combinations of the above specific examples of cation and the above specific examples of anion. Examples of preferable structures include those listed below. In the following formulae, tBu is a tert-butyl group.

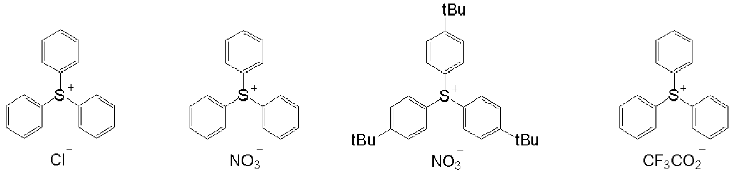

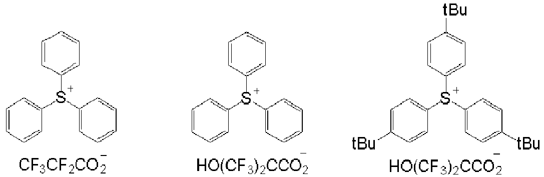

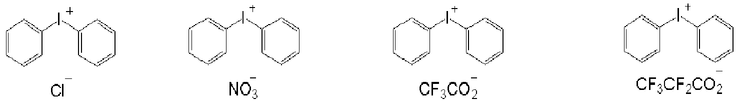

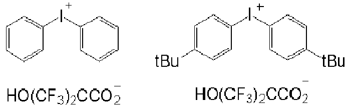

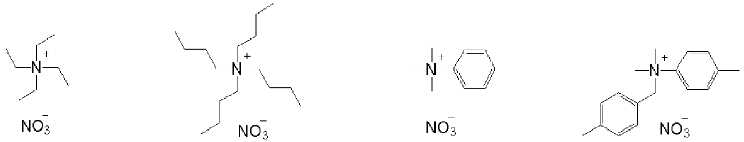

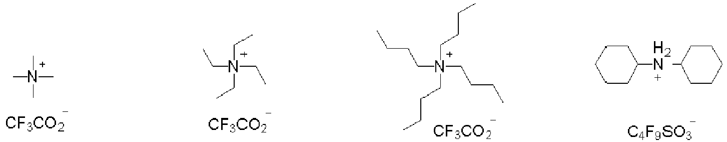

The base generator (C) is used singly or in combination of two or more to express basicity in accordance with the baking temperature of the composition for forming a resist underlayer film, and the balance between the film formability on a hydrophobic substrate and the planarizing property can be adjusted adequately. When the base generator (C) is added, the amount added is preferably 0.1 to 10 parts by mass, more preferably 0.3 to 5 parts by mass with respect to 100 parts by mass of the resin (A). When the amount of the base generator (C) added is within the range above, sufficient film formability-improving effect can be achieved to prevent deterioration of inplane uniformity of the film due to decomposition and sublimation, or reduction in curability of the compound or resin due to basicity.

The base generator (C) used in the composition for forming a resist underlayer film is more preferably the one represented by the general formula (2) or (4) and particularly preferably the one represented by the general formula (2).

It is preferable that a composition further containing one or more selected from a crosslinking agent (D), a flowability accelerator (E), and a surfactant (F) is used as the composition for forming a resist underlayer film.

### (D) Crosslinking Agent

A crosslinking agent (D) may be added to the composition for forming a resist underlayer film used in the pattern forming method of the present invention. The crosslinking agent used is not limited and various known crosslinking agents can be used. Examples thereof include methylol or alkoxymethyl-type crosslinking agents of polynuclear phenols (polynuclear phenol-based crosslinking agent), melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, and epoxy-based crosslinking agents. When the crosslinking agent (D) is added, the amount added is preferably 1 to 50 parts by mass and more preferably 5 to 30 parts by mass with respect to 100 parts by mass of the resin (A).

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agents include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate] .

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis(4,5-diphenyl-2-oxazoline), 2,2'-methylenebis-4-phenyl-2-oxazoline, 2,2'-methylenebis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include compounds represented by the following general formula (XL-1), 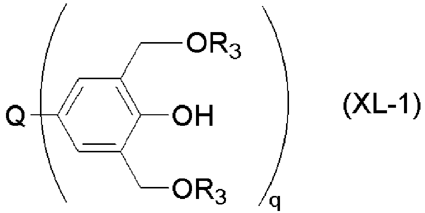 wherein Q represents a single bond or a hydrocarbon group with a valency of "q" having 1 to 20 carbon atoms; R₃ represents a hydrogen atom or an alkyl group having 1 to 20 carbon atoms; and "q" represents an integer of 1 to 5.

Q represents a single bond or a hydrocarbon group with a valency of q having 1 to 20 carbon atoms. "q" represents an integer of 1 to 5, more preferably 2 or 3. Specific examples of Q include groups having "q" hydrogen atoms removed from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, eicosane. R₃ represents a hydrogen atom or an alkyl group having 1 to 20 carbon atoms. Specific examples of the alkyl group having 1 to 20 carbon atoms include methyl, ethyl, propyl, isopropyl, butyl, isobutyl, penthyl, isopenthyl, hexyl, octyl, ethylhexyl, decyl, and eicosanyl groups. A hydrogen atom or a methyl group is preferred.

Specific examples of the compound represented by the general formula (XL-1) include the following compounds. Among these, hexamethoxymethylated products of triphenolmethane, triphenolethane, 1,1,1-tris(4-hydroxyphenyl)ethane, tris(4-hydroxyphenyl)-1-ethyl-4-isopropylbenzene are preferred in terms of improvement in curability and film thickness uniformity of the resist underlayer film. R₃ is as defined above.

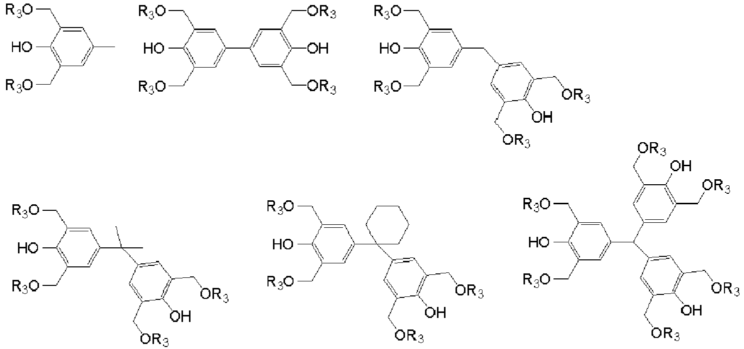

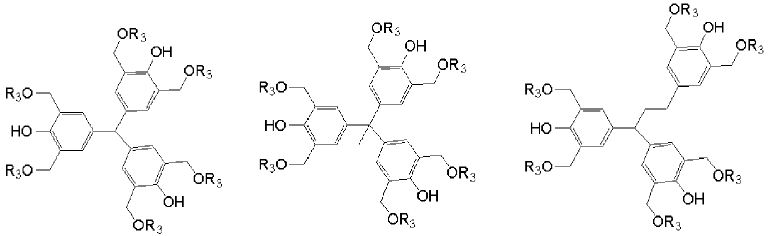

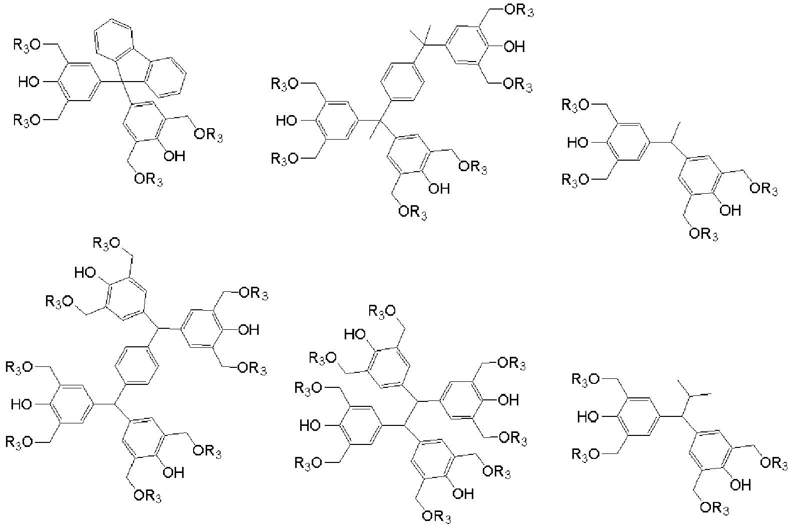

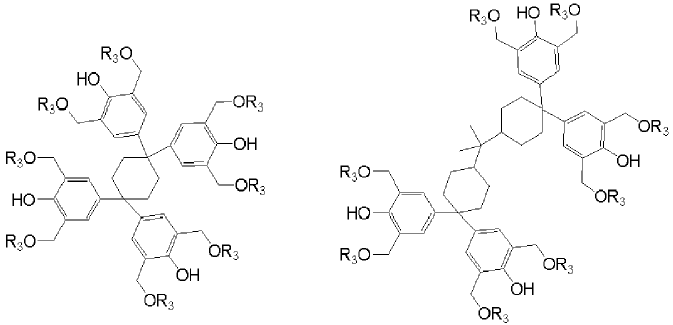

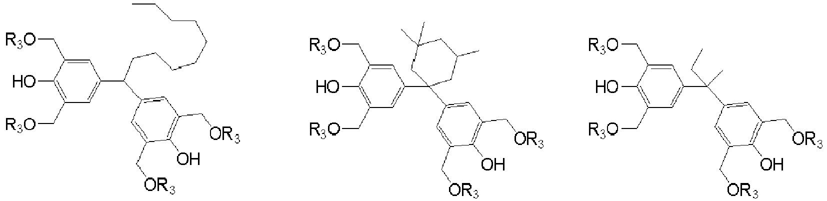

### (E) Flowability Accelerator

The composition for forming a resist underlayer film used in the pattern forming method of the present invention can further contain a flowability accelerator (E). The flowability accelerator (E) preferably has a weight loss ratio between 30°C and 190°C of less than 30% and a weight loss ratio between 30°C and 350°C of 98% or more.

The flowability accelerator with a weight loss ratio between 30°C and 190°C of less than 30% and a weight loss ratio between 30°C and 350°C of 98% or more is preferable because evaporation during heat treatment is suppressed, and thus low viscosity is sufficiently maintained, thermal flowability is excellent, and the amount of residual flowability accelerator in the resist underlayer film after baking is small. The weight loss ratio herein is based on a value determined by thermogravimetry (TG) using a differential thermal analyzer.

The upper limit of the temperature range in which the weight loss ratio of the flowability accelerator (E) is less than 30% is more preferably 210°C and even more preferably 230°C. Setting the temperature range in which the weight loss ratio of the flowability accelerator is less than 30% to the above temperature range can further improve the filling/planarizing properties.

The upper limit of the temperature range in which the weight loss ratio of the flowability accelerator (E) is 98% or more is more preferably 330°C and even more preferably 310°C. Setting the temperature in which the weight loss ratio of the flowability accelerator is 98% or more to the above temperature range can reduce the residual flowability accelerator in the resist underlayer film after baking.

Blending the flowability accelerator as described above improves the thermal flowability from the start of heat treatment of the composition for forming a resist underlayer film to curing by a crosslinking reaction and thus provides excellent filling/planarizing properties. On the other hand, the flowability accelerator is decreased due to evaporation of the like by heat treatment and therefore does not impair etching resistance or optical properties.

Examples of even more preferable forms of the flowability accelerator (E) include one or more compounds selected from the following general formulae (i) to (iii), 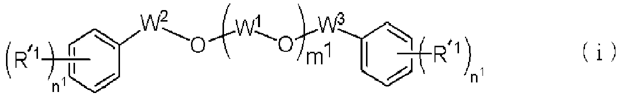
wherein R'¹s each independently represent a hydrogen atom, a hydroxyl group, or an optionally substituted organic group having 1 to 10 carbon atoms; W¹ represents a phenylene group or a divalent group represented by the following general formula (i-1); W² and W³ each represent a single bond or a divalent group represented by any one of the following formulae (i-2); "m¹" represents an integer of 1 to 10, and "n¹" represents an integer of 0 to 5, 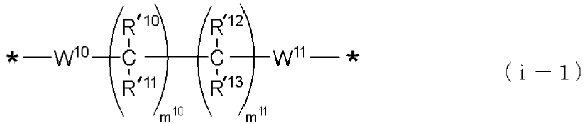
wherein * represents a bonding site, R'¹⁰, R'¹¹, R'¹², and R'¹³ each represent a hydrogen atom, a hydroxyl group, or an organic group having 1 to 10 carbon atoms; W¹⁰ and W¹¹ each independently represent a single bond or a carbonyl group; "m¹⁰" and "m¹¹" each represent an integer of 0 to 10, and m¹⁰+m¹¹≥1, 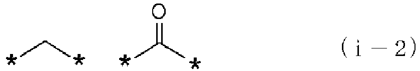
wherein * represents a bonding site, 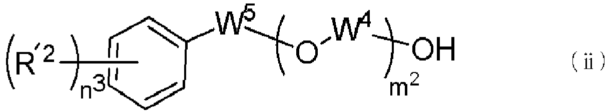
wherein R'²s each independently represent a hydrogen atom or an optionally substituted organic group having 1 to 10 carbon atoms; W⁴ represents a divalent group represented by the following general formula (ii-1); W⁵ represents a single bond or a divalent group represented by any one of the following formulae (ii-2); "m²" represents an integer of 2 to 10, and "n³" represents an integer of 0 to 5, 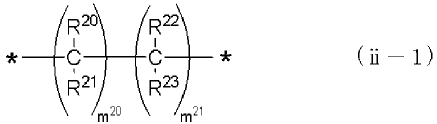
wherein * represents a bonding site, R²⁰, R²¹, R²², and R²³ each represent a hydrogen atom, a hydroxyl group, or an organic group having 1 to 10 carbon atoms; "m²⁰" and "m²¹" each represent an integer of 0 to 10, and m²⁰+m²¹≥1, 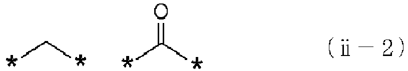
wherein * represents a bonding site, 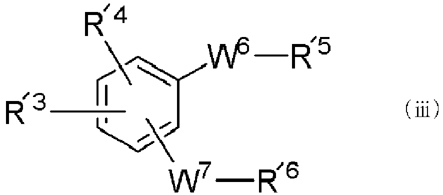
wherein R'³ and R'⁴ each represent a hydrogen atom, a hydroxyl group, or an optionally substituted organic group having 1 to 10 carbon atoms and may bond together to form a cyclic structure; R'⁵ and R'⁶ each represent an organic group having 1 to 10 carbon atoms, and R'⁵ represents a group containing one of an aromatic ring or a divalent group represented by the following general formula (iii-1); W⁶ and W⁷ each represent a single bond or a divalent group represented by any one of the following formulae (iii-2), and at least one of W⁶ and W⁷ is a divalent group represented by any one of the following formulae (iii-2), 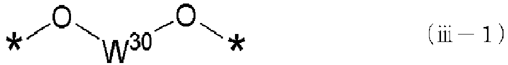
wherein * represents a bonding site; and W³⁰ represents an organic group having 1 to 4 carbon atoms, 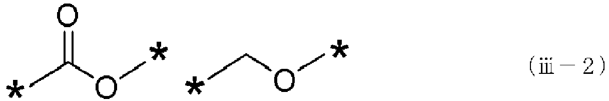
wherein * represents a bonding site.

In the general formula (i), R'¹s each independently represent a hydrogen atom, a hydroxyl group, or an optionally substituted organic group having 1 to 10 carbon atoms.

Here, "organic group" in the present invention means a group that contains at least one carbon atom and may further contain a hydrogen atom, and may contain a nitrogen atom, an oxygen atom, a sulfur atom, a silicon atom, a halogen atom, and the like.

R'¹s may be of a single kind, or multiple kinds may coexist. More specific examples of R'¹ include a hydrogen atom, and hydroxyl, methyl, ethyl, vinyl, 2,2,2-trifluoroethyl, propyl, isopropyl, allyl, butyl, s-butyl, t-butyl, isobutyl, pentyl, cyclopentyl, hexyl, cyclohexyl, cyclohexenyl, decyl, methoxy, ethoxy, propoxy, isopropoxy, butoxy, s-butoxy, t-butoxy, norbornyl, adamantyl, phenyl, toluyl, xylyl, naphthyl, benzyl, 2-furanyl, and 2-tetrahydrofuranyl groups. Among these, a hydrogen atom is more preferred.

W¹ represents a phenylene group or a divalent group represented by the general formula (i-1). W² and W³ each represent a single bond or a divalent group represented by any one of the above formulae (i-2). "m¹" represents an integer of 1 to 10, and "n¹"s each independently represent an integer of 0 to 5.

More specifically, R'¹⁰, R'¹¹, R'¹², and R'¹³ each represent a hydrogen atom, a hydroxyl group, or an organic group having 1 to 10 carbon atoms. More specific examples include a hydrogen atom, and hydroxyl, methyl, ethyl, vinyl, 2,2,2-trifluoroethyl, propyl, isopropyl, allyl, butyl, s-butyl, t-butyl, isobutyl, pentyl, cyclopentyl, hexyl, cyclohexyl, cyclohexenyl, decyl, methoxy, ethoxy, propoxy, isopropoxy, butoxy, s-butoxy, t-butoxy, norbornyl, adamantyl, phenyl, toluyl, xylyl, naphthyl, benzyl, 2-furanyl, and 2-tetrahydrofuranyl groups. Among these, a hydrogen atom and a methyl group are more preferred, and a hydrogen atom is even more preferred.

W¹⁰ and W¹¹ each independently represent a single bond or a carbonyl group. "m¹⁰" and "m¹¹" each represent an integer of 0 to 10, and m¹⁰+m¹¹≥1.

In the general formula (ii), R'²s each independently represent a hydrogen atom or an optionally substituted organic group having 1 to 10 carbon atoms.

R'²s may be of a single kind, or multiple kinds may coexist. More specific examples of R'² include a hydrogen atom, and methyl, ethyl, vinyl, 2,2,2-trifluoroethyl, propyl, isopropyl, allyl, butyl, s-butyl, t-butyl, isobutyl, pentyl, cyclopentyl, hexyl, cyclohexyl, cyclohexenyl, decyl, methoxy, ethoxy, propoxy, isopropoxy, butoxy, s-butoxy, t-butoxy, norbornyl, adamantyl, phenyl, toluyl, xylyl, naphthyl, benzyl, 2-furanyl, and 2-tetrahydrofuranyl groups. Among these, a hydrogen atom is more preferred.

W⁴ represents a divalent group represented by the general formula (ii-1). W⁵ represents a single bond or a divalent group represented by any one of the formulae (ii-2). "m²" represents an integer of 2 to 10, and "n³" represents an integer of 0 to 5.

More specific examples of R²⁰, R²¹, R²², and R²³ include a hydrogen atom, and hydroxyl, methyl, ethyl, vinyl, 2,2,2-trifluoroethyl, propyl, isopropyl, allyl, butyl, s-butyl, t-butyl, isobutyl, pentyl, cyclopentyl, hexyl, cyclohexyl, cyclohexenyl, decyl, methoxy, ethoxy, propoxy, isopropoxy, butoxy, s-butoxy, t-butoxy, norbornyl, adamantyl, phenyl, toluyl, xylyl, naphthyl, benzyl, 2-furanyl, and 2-tetrahydrofuranyl groups. Among these, a hydrogen atom and a methyl group are more preferred, and a hydrogen atom is even more preferred.

"m²⁰" and "m²¹" each represent an integer of 0 to 10, and m²⁰+m²¹≥1.

In the general formula (iii), R'³ and R'⁴ each represent a hydrogen atom, a hydroxyl group, or an optionally substituted organic group having 1 to 10 carbon atoms and may bond together to form a cyclic structure. More specific examples include a hydrogen atom, and hydroxyl, methyl, ethyl, vinyl, 2,2,2-trifluoroethyl, propyl, isopropyl, allyl, butyl, s-butyl, t-butyl, isobutyl, pentyl, cyclopentyl, hexyl, cyclohexyl, cyclohexenyl, decyl, methoxy, ethoxy, propoxy, isopropoxy, butoxy, s-butoxy, t-butoxy, norbornyl, adamantyl, phenyl, toluyl, xylyl, naphthyl, benzyl, 2-furanyl, and 2-tetrahydrofuranyl groups. Among these, a hydrogen atom is more preferred.

R'⁵ represents an organic group having 1 to 10 carbon atoms and containing one of an aromatic ring or a divalent group represented by the general formula (iii-1). R'⁶ represents an organic group having 1 to 10 carbon atoms. Examples of the organic group having 1 to 10 carbon atoms can include the groups listed above for R'³ and R'⁴.

W⁶ and W⁷ each represent a single bond or a divalent group represented by any one of the formulae (iii-2), and at least one of W⁶ and W⁷ is a divalent group represented by any one of the formulae (iii-2).

W³⁰ represents an organic group having 1 to 4 carbon atoms. More specific examples include methylene, ethylene, propylene, butylene, trimethylene, and tetramethylene groups. Among these, an ethylene group is more preferred.

More specific examples of the compound represented by the general formula (i) include, but not limited to, the following compounds.

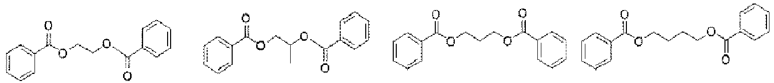

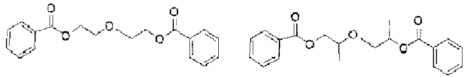

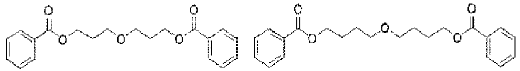

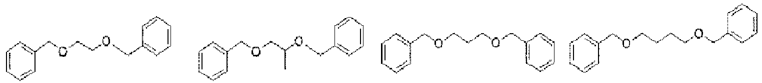

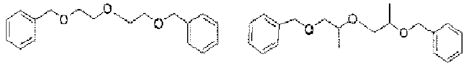

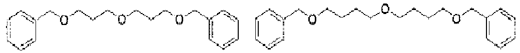

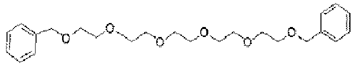

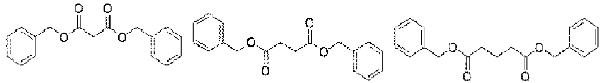

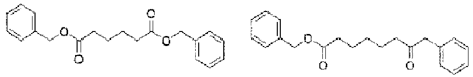

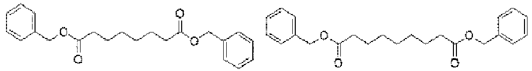

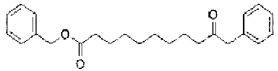

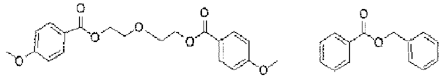

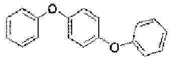

More specific examples of the compound represented by the general formula (ii) include, but not limited to, the following compounds.

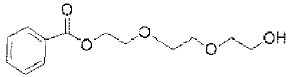

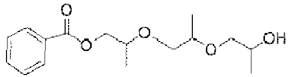

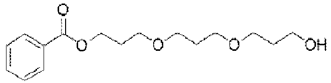

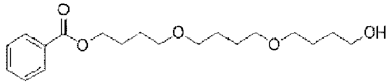

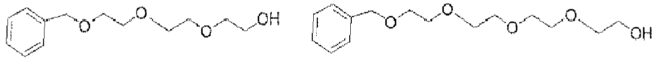

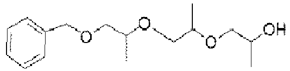

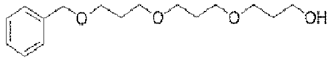

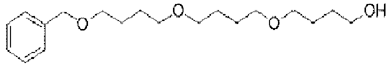

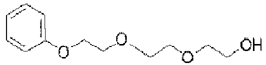

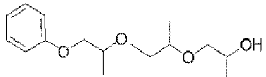

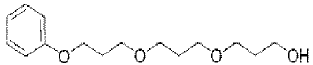

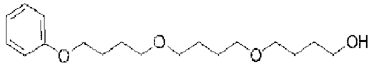

More specific examples of the compound represented by the general formula (iii) include, but not limited to, the following compounds.

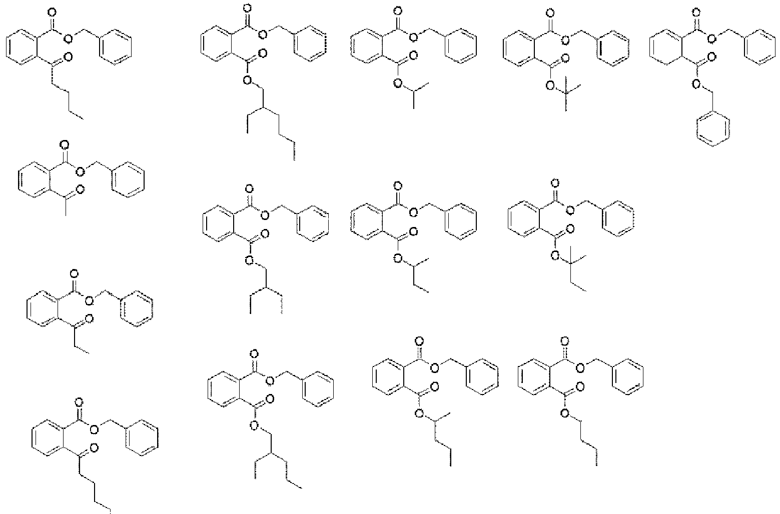

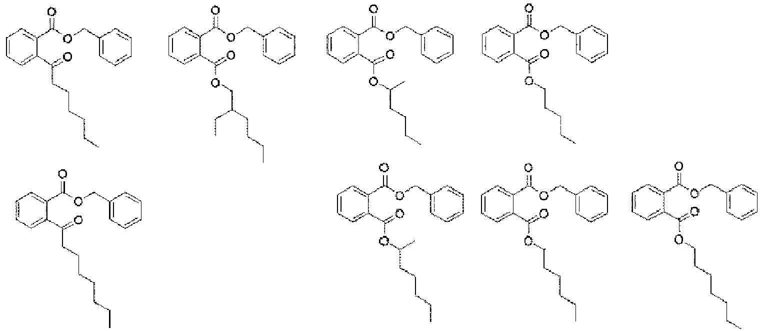

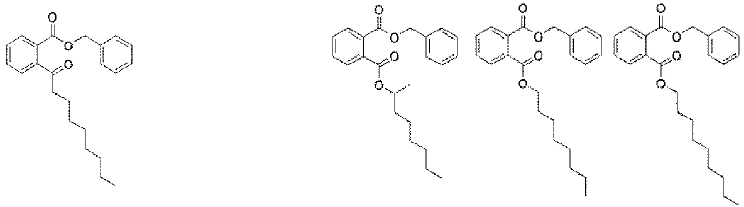

Considering all factors including the film formability and substrate filling/planarizing performance in the composition for forming a resist underlayer film, the flowability accelerator (E) used in the composition for forming a resist underlayer film is preferably an aromatic group-containing compound having a benzyl group or a benzoyl group, and in particular, the following aromatic group-containing compounds are preferred.
(i) (Poly)ethylene glycol dibenzoate
(ii) (Poly)ethylene glycol dibenzyl ether
(iii) (Poly)propylene glycol dibenzyl ether
(iv) (Poly)butylene glycol dibenzyl ether
(v) Linear aliphatic dibenzyl dicarboxylate
(vi) (Poly)ethylene glycol monobenzyl ether
(vii) (Poly)phenyl ether

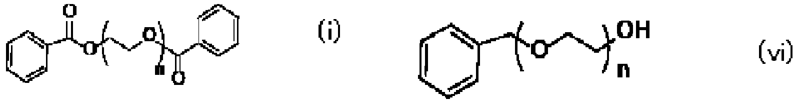

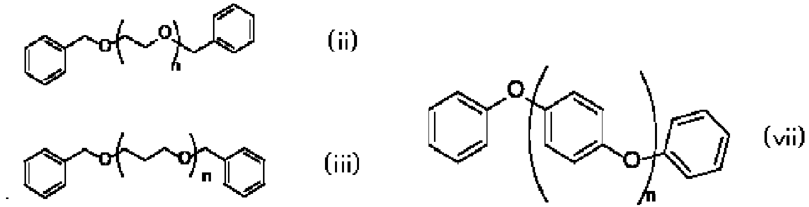

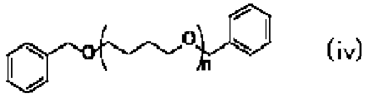

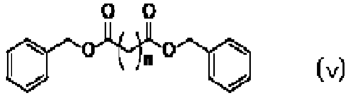

In the above formulae, "n" represents an integer in a range in which the molecular weight is 500 or less, which is applicable only in the above formulae.

It is preferable that the flowability accelerator (E) used in the composition for forming a resist underlayer film has a structure having both a hydrophobic portion including an aromatic ring and a hydrophilic portion including the following structure (E-1). Such a flowability accelerator (E) has excellent compatibility with the resin (A), the organic solvent (B), the base generator (C), and other additives and can improve the flowability of the composition without impairing film formability or storage stability.

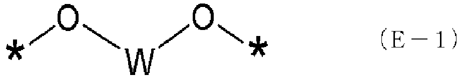

In the formula, * represents a bonding site, and W represents an organic group having 1 to 4 carbon atoms.

The amount of the flowability accelerator (E) added is preferably 5 to 100 parts by mass, more preferably 10 to 50 parts by mass with respect to 100 parts by mass of the resin (A). When the amount of the flowability accelerator (E) added is 5 parts by mass or more, the effect of improving the flowability of the composition for forming a resist underlayer film can be sufficiently obtained. On the other hand, when the amount of the flowability accelerator (E) added is 100 parts by mass or less, the film formability and dry-etching resistance of the resulting coating film are excellent.

The flowability accelerator (E) may be used singly or in combination of two or more.

### (F) Surfactant

A surfactant (F) can be added to the composition for forming a resist underlayer film used in the pattern forming method of present invention in order to improve application property in spin coating. As the surfactant (F), for example, those disclosed in [0142] to [0147] in JP 2009-269953 A can be used. When the surfactant (F) is added, the amount added is preferably 0.01 to 10 parts by mass, more preferably 0.05 to 5 parts by mass with respect to 100 parts by mass of the resin (A).

### (G) Plasticizer

A plasticizer (G) can also be added to the composition for forming a resist underlayer film used in the pattern forming method of the present invention in order to further improve planarizing/filling properties. The plasticizer (G) is not limited and various known plasticizers can be used. Examples include low molecular weight compounds such as phthalate esters, adipate esters, phosphate esters, trimellitate esters, and citrate esters, and polymers such as polyethers, polyesters, and polyacetal-based polymers disclosed in JP 2013-253227 A. When the plasticizer (G) is added, the amount added is preferably 1 to 100 parts by mass, more preferably 5 to 30 parts by mass with respect to 100 parts by mass of the resin (A).

Further, in the composition for forming a resist underlayer film of the present invention, for example, a liquid additive having a polyethylene glycol or polypropylene glycol structure or a thermally decomposable polymer having a weight loss ratio between 30°C and 250°C of 40% by mass or more and a weight average molecular weight of 300 to 200,000 is preferably used as an additive for imparting filling/planarizing properties in the same manner as the plasticizer. This thermally decomposable polymer preferably contains a repeating unit having an acetal structure represented by the following general formula (DP1) or (DP1a). 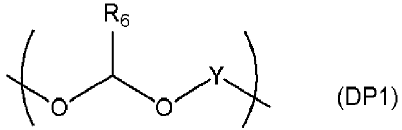 In the general formula (DP1), R₆ represents a hydrogen atom or an optionally substituted saturated or unsaturated monovalent organic group having 1 to 30 carbon atoms; and Y represents a saturated or unsaturated divalent organic group having 2 to 30 carbon atoms. 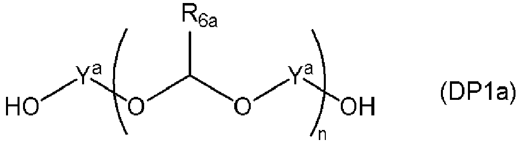 In the general formula (DP1a), R₆ₐ represents an alkyl group having 1 to 4 carbon atoms; Y^{a} represents a saturated or unsaturated divalent hydrocarbon group having 4 to 10 carbon atoms and optionally having an ether bond; and "n" represents the average number of repeating units and is 3 to 500.

### EXAMPLE

Hereinafter, the present invention will be specifically described with reference to Examples and Comparative Examples. However, the present invention is not limited thereto. The molecular weight and the dispersity were measured by the following method. The weight average molecular weight (Mw) in terms of polystyrene and the dispersity (Mw/Mn) were determined by gel permeation chromatography (GPC) using tetrahydrofuran as an eluent.

Resin raw materials:

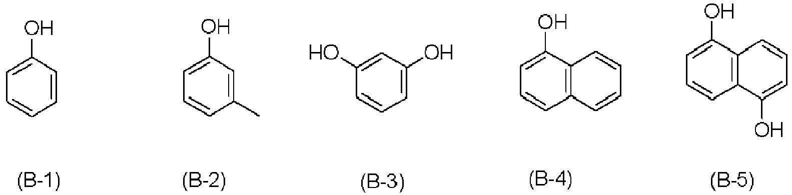

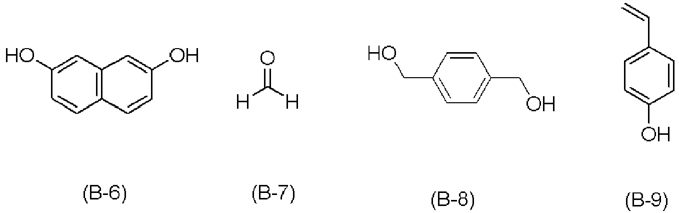

Resins used as intermediates:

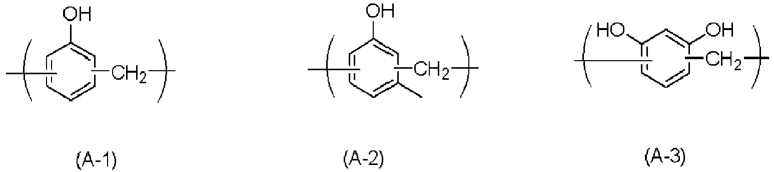

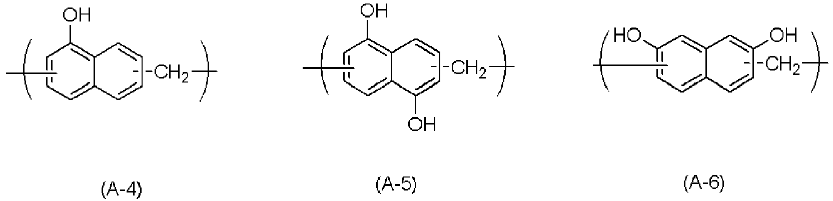

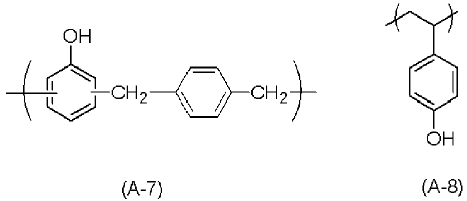

Modifiers:

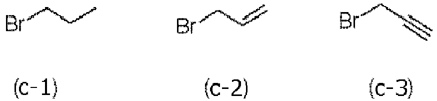

The resins (A-1) to (A-8) shown above were synthesized as follows.

### (Synthesis Example A-1)

### Synthesis of Resin (A-1)

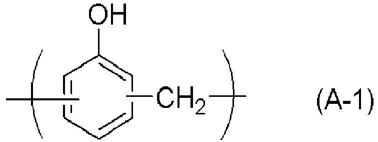

In a nitrogen atmosphere, 188.2 g of the resin raw material (B-1), 81.3 g of the resin raw material (B-7), 9.0 g of oxalic acid, and 100 g of dioxane were added and allowed to react at an internal temperature of 100°C for 24 hours. After completion of the reaction, the reaction product was cooled to room temperature, and 2,000 ml of MIBK was added. The mixture was washed with 500 ml of pure water six times. The organic layer was collected, and the pressure was reduced to 2 mmHg at an internal temperature of 150°C to remove the moisture, solvent, and residual monomers under reduced pressure, resulting in the resin (A-1).

The weight average molecular weight (Mw) and the dispersity (Mw/Mn) were determined by GPC. The result was as follows.
(A-1): Mw=2,500, Mw/Mn=2.87

### (Synthesis Example A-2)

### Synthesis of Resin (A-2)

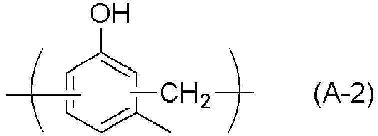

In a nitrogen atmosphere, 216.3 g of the resin raw material (B-2), 81.3 g of the resin raw material (B-7), 10.8 g of oxalic acid, and 200 g of dioxane were added and allowed to react at an internal temperature of 100°C for 24 hours. After completion of the reaction, the reaction product was cooled to room temperature, and 2,000 ml of MIBK was added. The mixture was washed with 500 ml of pure water six times. The organic layer was collected, and the pressure was reduced to 2 mmHg at an internal temperature of 150°C to remove the moisture, solvent, and residual monomers under reduced pressure, resulting in the resin (A-2).

The weight average molecular weight (Mw) and the dispersity (Mw/Mn) were determined by GPC. The result was as follows.
(A-2): Mw=3,300, Mw/Mn=3.50

### (Synthesis Example A-3)

### Synthesis of Resin (A-3)

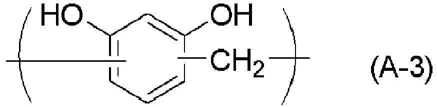

In a nitrogen atmosphere, 144.2 g of the resin raw material (B-3), 53.2 g of the resin raw material (B-7), and 250 g of propylene glycol monomethyl ether (PGME) were added and homogenized at an internal temperature of 100°C. Subsequently, a mixture of 3.0 g of p-toluenesulfonic acid monohydrate and 7.1 g of PGME mixed and homogenized in advance was slowly added dropwise to allow a reaction to proceed at an internal temperature of 120°C for 8 hours. After completion of the reaction, the reaction solution was cooled to room temperature, and 2,000 ml of MIBK was added. The mixture was washed with 500 ml of pure water six times, and the organic layer was evaporated to dryness under reduced pressure, resulting in the resin (A-3).

The weight average molecular weight (Mw) and the dispersity (Mw/Mn) were determined by GPC. The result was as follows.
(A-3): Mw=2,900, Mw/Mn=2.26

### (Synthesis Example A-4)

### Synthesis of Resin (A-4)

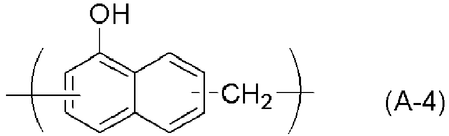

In a nitrogen atmosphere, 144.2 g of the resin raw material (B-4), 40.6 g of the resin raw material (B-7), and 250 g of propylene glycol monomethyl ether (PGME) were added and homogenized at an internal temperature of 100°C. Subsequently, a mixture of 3.0 g of p-toluenesulfonic acid monohydrate and 7.1 g of PGME mixed and homogenized in advance was slowly added dropwise to allow a reaction to proceed at an internal temperature of 120°C for 8 hours. After completion of the reaction, the reaction product was cooled to room temperature, and 2,000 ml of MIBK was added. The mixture was washed with 500 ml of pure water six times, and the organic layer was evaporated to dryness under reduced pressure, resulting in the resin (A-4).

The weight average molecular weight (Mw) and the dispersity (Mw/Mn) were determined by GPC. The result was as follows.
(A-4): Mw=3,300, Mw/Mn=2.26

### (Synthesis Example A-5)

### Synthesis of Resin (A-5)

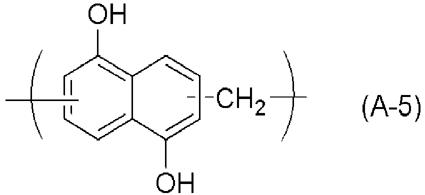

In a nitrogen atmosphere, 160.2 g of the resin raw material (B-5), 40.6 g of the resin raw material (B-7), and 250 g of propylene glycol monomethyl ether (PGME) were added and homogenized at an internal temperature of 100°C. Subsequently, a mixture of 3.2 g of p-toluenesulfonic acid monohydrate and 8.0 g of PGME mixed and homogenized in advance was slowly added dropwise to allow a reaction to proceed at an internal temperature of 120°C for 8 hours. After completion of the reaction, the reaction product was cooled to room temperature, and 2,000 ml of MIBK was added. The mixture was washed with 500 ml of pure water six times, and the organic layer was evaporated to dryness under reduced pressure, resulting in the resin (A-5).

The weight average molecular weight (Mw) and the dispersity (Mw/Mn) were determined by GPC. The result was as follows.
(A-5): Mw=3,400, Mw/Mn=2.54

### (Synthesis Example A-6)

### Synthesis of Resin (A-6)

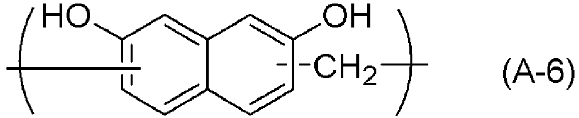

In a nitrogen atmosphere, 160.2 g of the resin raw material (B-6), 40.6 g of the resin raw material (B-7), and 300 g of propylene glycol monomethyl ether (PGME) were added and homogenized at an internal temperature of 100°C. Subsequently, a mixture of 3.2 g of p-toluenesulfonic acid monohydrate and 8.0 g of PGME mixed and homogenized in advance was slowly added dropwise to allow a reaction to proceed at an internal temperature of 120°C for 8 hours. After completion of the reaction, the reaction product was cooled to room temperature, and 2,000 ml of MIBK was added. The mixture was washed with 500 ml of pure water six times, and the organic layer was dried under reduced pressure, resulting in the resin (A-6) .

The weight average molecular weight (Mw) and the dispersity (Mw/Mn) were determined by GPC. The result was as follows.
(A-6): Mw=3,300, Mw/Mn=2.41

### (Synthesis Example A-7)

### Synthesis of Resin (A-7)

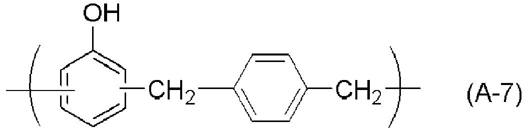

In a nitrogen atmosphere, 94.1 g of the resin raw material (B-1), 89.8 g of the resin raw material (B-8), and 400 g of dichloromethane were added to form a homogeneous dispersion liquid at an internal temperature of 30°C. Subsequently, 211 g of methanesulfonic acid was added for 2 hours to allow a reaction to proceed at an internal temperature of 30°C for 24 hours. After completion of the reaction, the reaction product was cooled to room temperature, and 2,000 ml of MIBK was added. The mixture was washed with 500 ml of pure water six times, and the organic layer was evaporated to dryness under reduced pressure. To the residue, 300 g of THF was added to form a homogeneous solution, which was then crystallized in 2,000 g of hexane. The sedimented crystals were fractionated by filtration, and washed with 500 g of hexane twice, and collected. The collected crystals were dried in a vacuum at 70°C, resulting in the resin (A-7).

The weight average molecular weight (Mw) and the dispersity (Mw/Mn) were determined by GPC. The result was as follows.
(A-7): Mw=6,300, Mw/Mn=3.11

### (Synthesis Example A-8)

### Synthesis of Comparative Resin (A-8)

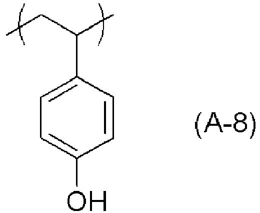

In a nitrogen atmosphere, 100.0 g of the monomer (B-9), 3.85 g of V-601 (dimethyl 2,2'-azobis(isobutyrate) available from Wako Pure Chemical Industries), and 340 g of propylene glycol monomethyl ether acetate (PGMEA) were weighed in a 1 L graduated cylinder and degassed under stirring to prepare a monomer-polymerization initiator solution. In another 1 L flask in a nitrogen atmosphere, 60 g of PGMEA was weighed and degassed under stirring, and then heated to an internal temperature of 80°C. The monomer-polymerization initiator solution was added dropwise for 4 hours, and then the solution was continuously stirred for 16 hours with the temperature of the polymer solution kept at 80°C, and then cooled to room temperature. The resulting polymer solution was added dropwise to 5,000 g of hexane vigorously stirred, and the precipitated polymer was filtered. Further, the resulting polymer was washed with 600 g of hexane twice and then dried in a vacuum at 50°C for 20 hours, resulting in the comparative resin (A-8) which was white powdery.

The weight average molecular weight (Mw) and the dispersity (Mw/Mn) were determined by GPC. The result was as follows.
(A-8): Mw=8,500, Mw/Mn=2.50

Synthesis of Resins (X-1) to (X-9), Comparative Resins (R-2) to (R-3), (R-5) to (R-6), and Comparative Compound (R-7)

### Synthesis Example 1

### Synthesis of Resin (X-1)

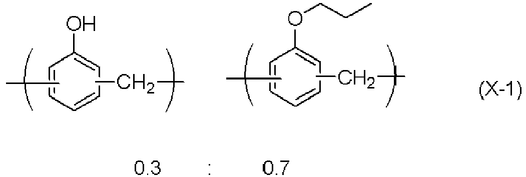

In a nitrogen atmosphere, 20.0 g of the resin (A-1), 31.3 g of potassium carbonate, and 100 g of DMF were added to form a homogeneous dispersion liquid at an internal temperature of 50°C. Then, 16.2 g of the modifier (c-1) was added slowly to allow a reaction to proceed at an internal temperature of 50°C for 24 hours. To the reaction solution, 300 ml of methyl isobutyl ketone and 300 g of pure water were added and the precipitated salt was dissolved. Then, the separated aqueous layer was removed. The resulting organic layer was added to 1,500 g of hexane, and the upper layer was removed. Subsequently, the resulting product was dissolved in 300 ml of methyl isobutyl ketone again and washed with 100 g of a 3% nitric acid aqueous solution and 100 g of pure water six times, and then the organic layer was evaporated to dryness under reduced pressure, resulting in a resin (X-1).

The weight average molecular weight (Mw) and the dispersity (Mw/Mn) were determined by GPC. The result was as follows.
(X-1): Mw=6,000, Mw/Mn=3.61

### Synthesis Example 2 to 14

### Synthesis of Resins (X-2) to (X-9) and Comparative Resins (R-2) to (R-3) and (R-5)

Resins (X-2) to (X-9) and comparative resins (R-2) to (R-3) and (R-5) listed in Tables 1 to 3 were obtained as products under the same reaction conditions as in Synthesis Example 1, except that the resins (A-1) to (A-8), the modifiers (c-1) to (c-3), and potassium carbonate were used in the amounts listed in Tables 1 to 3. The weight average molecular weight (Mw) and the dispersity (Mw/Mn) of these resins were determined and listed in Table 4. Those for (R-1) as the comparative resin (A-8) and (R-4) as the resin (A-2) were also listed.

**[Table 1]**

| Synthesi s Example | Resin | | Modifier | | Potassiu m carbonat e | Compound or polymer |
|---|---|---|---|---|---|---|
| | | g | | g | g | |
| 1 | A-1 | 20.0 | c-1 | 16.2 | 31.3 | 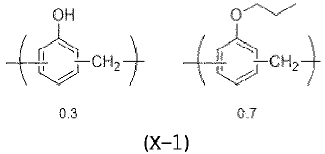 |
| 2 | A-2 | 20.0 | c-2 | 14.1 | 27.6 | 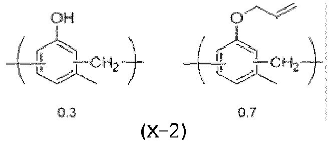 |
| 3 | A-2 | 20.0 | c-3 | 17.5 | 27.6 | 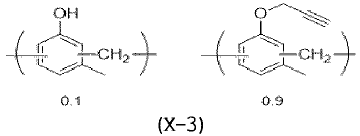 |
| 4 | A-3 | 20.0 | c-1 | 28.2 | 31.7 | 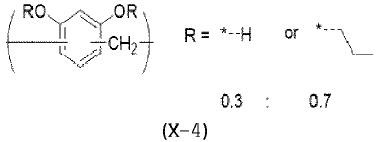 |
| 5 | A-4 | 20.0 | c-3 | 10.7 | 21.2 | 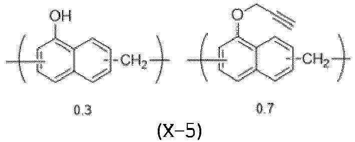 |
| 6 | A-5 | 20.0 | c-3 | 24.2 | 22.5 | 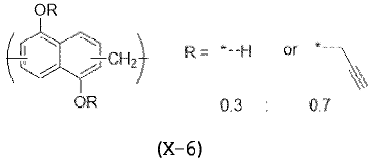 |

**[Table 2]**

| Synthesi s Example | Resin | | Modifier | | Potassiu m carbonat e | Compound or polymer |
|---|---|---|---|---|---|---|
| | | g | | g | g | |
| 7 | A-6 | 20.0 | c-3 | 24.2 | 22.5 | 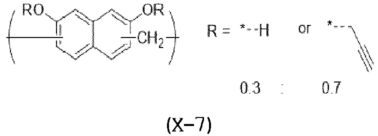 |
| 8 | A-7 | 20.0 | c-2 | 8.6 | 16.9 | 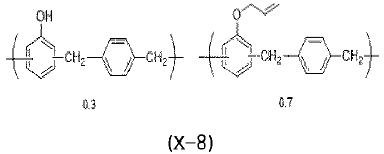 |
| 9 | A-7 | 20.0 | c-3 | 8.5 | 16.9 | 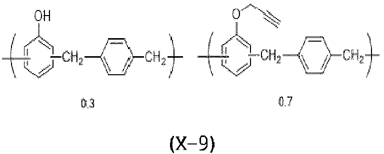 |

**[Table 3]**

| Synthesis Example | Resin | | Modifier | | Potassium carbonate | Compound or polymer |
|---|---|---|---|---|---|---|
| | | g | | g | g | |
| 10 | A-8 | 20.0 | - | - | - | 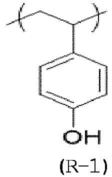 |
| 11 | A-8 | 20.0 | c-2 | 24.2 | 27.6 | 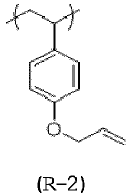 |
| 12 | A-8 | 20.0 | c-3 | 29.8 | 27.6 | 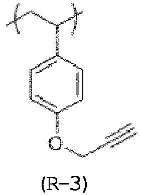 |
| 13 | A-2 | 20.0 | - | - | - | 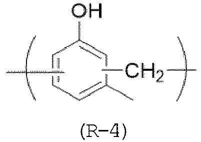 |
| 14 | A-2 | 20.0 | c-3 | 23.8 | 34.5 | 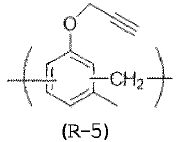 |

### Synthesis Examples 15 to 16

### Synthesis of Comparative Resin (R-6) and Comparative Compound (R-7)

The following raw materials were used for synthesis of comparative resin (R-6) and comparative compound (R-7) .

### Raw materials:

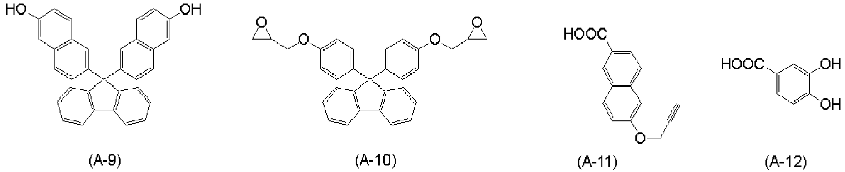

### Synthesis Example 15

### Synthesis of Comparative Resin (R-6)

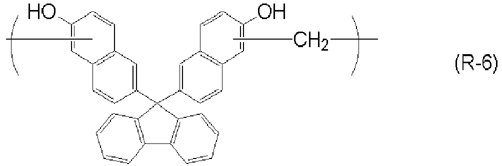

In a nitrogen atmosphere, 90.1 g of the raw material (A-9), 9.7 g of the resin raw material (B-8), and 270 g of 2-methoxy-1-propanol were added to form a homogeneous solution at a liquid temperature of 80°C. Then, 18 g of a 2-methoxy-1-propanol solution of 20% p-toluenesulfonic acid was added slowly, and the mixture was stirred at a liquid temperature of 110°C for 8 hours. After cooling to room temperature, 600 g of methyl isobutyl ketone was added, and the organic layer was washed with 200 g of pure water five times. Then, the organic layer was evaporated to dryness under reduced pressure. To the residue, 320 g of THF was added, and the polymer was reprecipitated in 1,350 g of hexane. The precipitated polymer was fractionated by filtration and dried under reduced pressure, resulting in a comparative resin (R-6).

The weight average molecular weight (Mw) and the dispersity (Mw/Mn) were determined by GPC. The result was as follows.
(R-6): Mw=3,460, Mw/Mn=4.60

### Synthesis Example 16

### Synthesis of Comparative Compound (R-7)

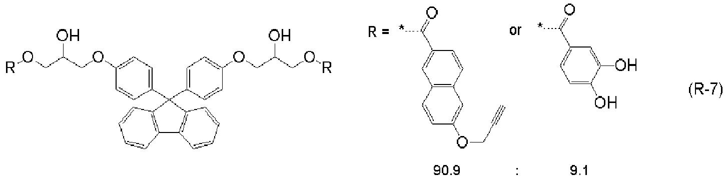

In a nitrogen atmosphere, 15.4 g of the raw material (A-10), 13.6 g of the raw material (A-11), 1.0 g of the raw material (A-12), and 60 g of 2-methoxy-1-propanol were stirred at an internal temperature of 100°C to form a homogeneous solution. Then, 1.00 g of benzyltriethylammonium chloride was added and the mixture was stirred at an internal temperature of 110°C for 12 hours. After cooling to room temperature, 200 ml of methyl isobutyl ketone was added, and the mixture was washed with 100 g of a 1 wt% ammonia aqueous solution twice, with 100 g of a 3% nitric acid aqueous solution twice, and with 100 g of ultrapure water five times, in this order. The organic layer was evaporated to dryness under reduced pressure, resulting in a comparative compound (R-7).

The weight average molecular weight (Mw) and the dispersity (Mw/Mn) were determined by GPC. The result was as follows.
(R-7): Mw=910, Mw/Mn=1.03

**[Table 4]**

| Resin (A) | Mw | Mw/Mn |
|---|---|---|
| X-1 | 6,000 | 3.61 |
| X-2 | 7,400 | 3.51 |
| X-3 | 8,000 | 3.60 |
| X-4 | 6,500 | 3.10 |
| X-5 | 5,900 | 2.43 |
| X-6 | 7,000 | 2.68 |
| X-7 | 6, 600 | 2.83 |
| X-8 | 7,200 | 3.41 |
| X-9 | 7,100 | 3.35 |
| R-1 | 8,500 | 2.50 |
| R-2 | 10,000 | 2.55 |
| R-3 | 10,000 | 2.60 |
| R-4 | 3,300 | 3.50 |
| R-5 | 9,400 | 3.59 |
| R-6 | 3,460 | 4.60 |
| R-7 | 910 | 1.03 |

### Preparation of Composition for Forming Resist Underlayer Film (UL-1 to 10, Comparative Examples UL-1 to 8)

The resins (X-1) to (X-9) and (R-1) to (R-7), base generators (C-1) to (C-4), a crosslinking agent (D-1), and a flowability accelerator (E-1) were dissolved in the proportions listed in Table 6 in an organic solvent containing 0.1% by mass of FC-4430 (a product from 3M Corporation was purified in-house), and the solution was filtered through a 0.1 µm fluorinated resin filter to prepare compositions for forming a resist underlayer film (UL-1 to 10, Comparative Examples UL-1 to 8).

### (C) Base Generator

The base generators (C-1 to C-4) used in the compositions for forming a resist underlayer film are as follows.

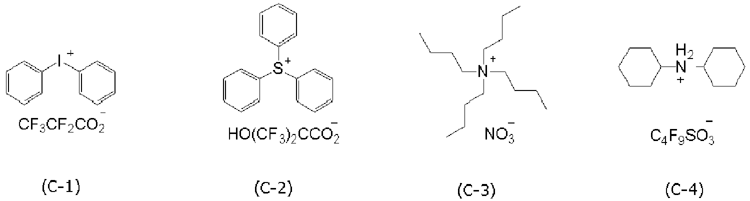

### (D) Crosslinking Agent

The crosslinking agent (D-1) used in the compositions for forming a resist underlayer film is as follows.

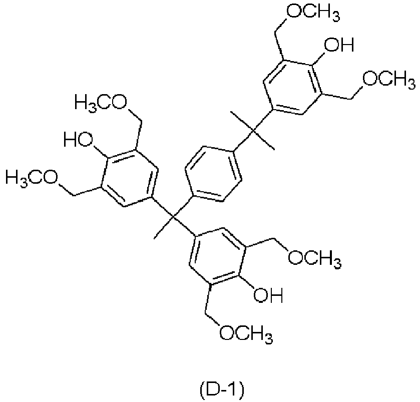

### (E) Flowability Accelerator

The flowability accelerator (E-1) used in the compositions for forming a resist underlayer film is shown in Table 5 below.

**[Table 5]**

| Compound or polymer | Mw (calculated value) | Weight loss ratio between 30°C and 190°C (%) | Weight loss ratio between 30°C and 350°C (%) |
|---|---|---|---|
| 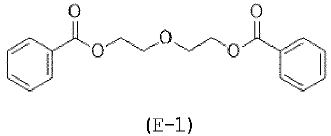 | 314 | 1 | 100 |

**[Table 6]**

| Composition for forming | Resin (A) | Base generator (C) | Crosslinking agent (D) | Flowability promotor (E) | Organic solvent (B) |
|---|---|---|---|---|---|
| resist underlayer film | (Parts by mass) | (Parts by mass) | (Parts by mass) | (Parts by mass) | (Parts by mass) |
| UL-1 | (X-1) (100) | - | - | - | PGMEA (200) |
| UL-2 | (X-2) (100) | - | - | - | PGMEA (200) |
| UL-3 | (X-3) (100) | - | - | - | PGMEA (200) |
| UL-4 | (X-4) (100) | - | - | - | PGMEA (200) |
| UL-5 | (X-5) (100) | (C -1) (0.5) | - | - | PGMEA (200) |
| UL-6 | (X-6) (100) | (C -2) (0.5) | - | - | PGMEA (200) |
| UL-7 | (X-7) (100) | (C -3) (0.5) | - | - | PGMEA (200) |
| UL-8 | (X-8) (100) | (C -4) (0.5) | - | - | PGMEA (200) |
| UL-9 | (X-9) (100) | - | D-1 (30) | - | PGMEA (200) |
| UL-10 | (R-4) / (R-5) (50/50) | - | - | E-1 (30) | PGMEA (200) |
| Comparative example UL-1 | (R-1) (100) | - | - | - | PGMEA (200) |
| Comparative example UL-2 | (R-2) (100) | - | - | - | PGMEA (200) |
| Comparative example UL-3 | (R-3) (100) | - | - | - | PGMEA (200) |
| Comparative example UL-4 | (R-4) (100) | - | - | - | PGMEA (200) |
| Comparative example UL-5 | (R-5) (100) | - | - | - | PGMEA (200) |
| Comparative example UL-6 | (R-1) / (R-2) (80/20) | - | - | - | PGMEA (200) |
| Comparative example UL-7 | (R-6) (100) | - | - | - | PGMEA (200) |
| Comparative example UL-8 | (R-7) (100) | - | - | - | PGMEA (200) |

### Solvent Resistance Evaluation and Film Thickness Uniformity Evaluation (Examples 1-1 to 1-10, Comparative Examples 1-1 to 1-8)

The compositions for forming a resist underlayer film (UL-1 to 10, Comparative Examples UL-1 to 8) prepared above were each applied on a silicon substrate and baked at an individual baking temperature for 60 seconds. Then, the film thicknesses from the center to the outer periphery of the substrate were measured and the average film thickness (a [nm]) was calculated. Subsequently, a PGMEA solvent was dispensed thereon, left for 30 seconds, spin-dried, and baked at 100°C for 60 seconds to evaporate PGMEA. The film thickness (b [nm]) was measured. The film thickness difference (remaining film ratio: (b/a)×100) between before and after PGMEA treatment was determined.

For each of the resist underlayer films baked under respective conditions, the film thicknesses from the center to the outer periphery of the substrate were measured. Among these, when the film thickness difference between the maximum film thickness and the minimum film thickness was less than 5% relative to the average film thickness (a), the resist underlayer film was evaluated as being "good", and when 5% or more, the resist underlayer film was evaluated as being "poor". Further, the film formability of each of the produced resist underlayer films was observed with an optical microscope. If there were no defects such as cracking and wrinkles, the resist underlayer film was evaluated as being "good". If cracking and/or wrinkles were observed, the resist underlayer film was evaluated as being "poor".

The results are listed in Table 7 below.

**[Table 7]**

| Example | Composition for forming | Baking temperature | Film formability | Film thickness after formation : a | Film thickness uniformity | Film thickness after solvent treatment : b | b/a ×100 |
|---|---|---|---|---|---|---|---|
| | resist underlayer film | | | F1 | | Å | % |
| Ex. 1-1 | UL-1 | 250°C | Good | 30,500 | Good | 30,500 | 100% |
| Ex. 1-2 | UL-2 | 250°C | Good | 30,200 | Good | 30,200 | 100% |
| Ex. 1-3 | UL-3 | 250°C | Good | 30,300 | Good | 30,300 | 100% |
| Ex. 1-4 | UL-4 | 250°C | Good | 29,900 | Good | 29,900 | 100% |
| Ex. 1-5 | UL-5 | 250°C | Good | 30,000 | Good | 30,000 | 100% |
| Ex. 1-6 | UL-6 | 250°C | Good | 30,100 | Good | 30,100 | 100% |
| Ex. 1-7 | UL-7 | 250°C | Good | 30,200 | Good | 30,200 | 100% |
| Ex. 1-8 | UL-8 | 250°C | Good | 30,400 | Good | 30,300 | 100% |
| Ex. 1-9 | UL-9 | 250°C | Good | 30,400 | Good | 30,300 | 100% |
| Ex. 1-10 | UL-10 | 250°C | Good | 30,500 | Good | 30,500 | 100% |
| Comp. Ex. 1-1 | Comparative Example UL-1 | 250°C | Good | 29,400 | Poor | 29,400 | 100% |
| Comp. Ex. 1-2 | Comparative Example UL-2 | 250°C | Good | 29,300 | Good | 29,300 | 100% |
| Comp. Ex. 1-3 | Comparative Example UIr3 | 250°C | Good | 30,300 | Good | 30,300 | 100% |
| Comp. Ex. 1-4 | Comparative Example UL-4 | 250°C | Good | 30,600 | Poor | 30,600 | 100% |
| Comp. Ex. 1-5 | Comparative Example UL-5 | 250°C | Good | 29,600 | Good | 29,600 | 100% |
| Comp. Ex. 1-6 | Comparative Example UL-6 | 250°C | Good | 29,400 | Poor | 29,400 | 100% |
| Comp. Ex. 1-7 | Comparative Example UL-7 | 350°C | Poor (cracking) | 30, 650 | Poor | 30, 650 | 100% |
| Comp. Ex. 1-8 | Comparative Example UL-8 | 250°C | Poor (cracking) | 30,300 | Poor | 30,300 | 100% |

As shown in Table 7, Examples 1-1 to 1-10 using UL-1-1 to 1-10 which are compositions for forming a resist underlayer film used in the pattern forming method of the present invention exhibit good film formability and film thickness uniformity in forming a thick film. Further, the remaining film ratio ((b/a)×100) after the PGMEA rinsing treatment is 99% or more, indicating that a crosslinking reaction occurs and sufficient solvent resistance is expressed.

On the other hand, in Comparative Examples 1-1, 1-4, and 1-6 using Comparative Examples UL-1, UL-4, and UL-6, respectively, in which the content of the group in which a phenolic hydroxyl group is modified falls outside the range of the present invention, poor film thickness uniformity was observed, probably because the resin has a high viscosity and the flowability in spin coating is insufficient.

Further, in Comparative Example 1-7 using Comparative Example UL-7 containing the comparative resin (R-6) having a rigid cardo structure, and Comparative Example 1-8 using Comparative Example UL-8 containing the comparative compound (R-7) that is a monomolecular compound, cracking was observed in the surface of the resist underlayer film after baking the substrate. In addition, poor film thickness uniformity due to the presence of cracking was found. It can be said that when a film as thick as 3 µm or more is formed, it is preferable to use a resin containing any one of a novolac phenol unit and a novolac naphthol unit.

### Etching Resistance (Examples 2-1 to 2-10, Comparative Examples 2-1 to 2-7)

The compositions for forming a resist underlayer film (UL-1 to 10, Comparative Examples UL-1 to 6) with the above solvent resistance evaluation being good were each applied on a silicon substrate and baked at 250°C for 60 seconds using a hot plate to form a resist underlayer film. Then, the film thickness "a" was measured. As a comparative example, a comparative example KrF resist material was applied on a silicon substrate and baked using a hot plate at 100°C for 60 seconds to form a resist upper layer film. Then, the film thickness "a" was measured.

The comparative example KrF resist material (KrF monolayer resist) was prepared by dissolving a polymer represented as KrF monolayer resist polymer (KRP1), acid generators (PAG2 and PAG3), and a basic compound (Amine2) in a solvent containing 0.1% by mass of a surfactant FC-4430 (manufactured by Sumitomo 3M Limited) in the proportions listed in Table 8, and filtering the solution through a 0.1 µm fluorinated resin filter.

**[Table 8]**

| | Polymer | Acid generator 1 | Acid generator 2 | Basic compound | Surfactant | Solvent 1 | Solvent 2 |
|---|---|---|---|---|---|---|---|
| | (Parts by mass) | (Parts by mass) | (Parts by mass) | (Parts by mass) | (Parts by mass) | (Parts by mass) | (Parts by mass) |
| KrF monolayer resist | KPR1 | PAG2 | PAG3 | Amine2 | FC-4430 | PGMEA | Ethyl lactate |
| | 80 | 1 | 2 | 0.2 | 0.5 | 70 | 160 |

### KrF monolayer resist polymer (KRP1)

### Mw=15,000, Mw/Mn=1.98

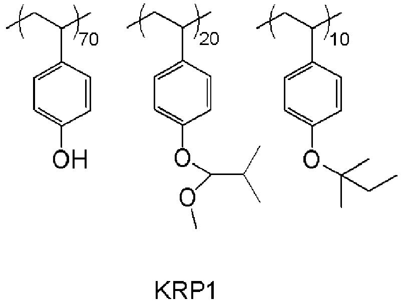

### PAG2 (acid generator): diphenylsulfonium (4-butoxyphenyl) 10-camphorsulfonate

PAG3 (acid generator):
bis(cyclohexylsulfonyl)diazomethane
Amine2 (basic compound): tris(2-methoxyethyl)amine

Subsequently, etching was performed using an etching apparatus Telius manufactured by Tokyo Electron Limited using CF₄ gas under the following conditions, and the film thickness "b" was measured. The film thickness etched for one minute was calculated from the film thickness etched for a specified time using CF₄ gas (film thickness "a" - film thickness "b"), as an etching rate A (nm/min). When the etching rate A was 75 nm/min or less, the evaluation was "A" (good), when the etching rate was greater than 75 nm/min and 80 nm/min or less, the evaluation was "B" (fair). When the etching rate was greater than 80 nm/min, the evaluation was "C" (poor). The results are listed in Table 9.

The etching conditions are as follows.
CF₄ Gas Dry-Etching Conditions
Chamber pressure: 50 mT
RF power (upper): 500 W
RF power (lower): 300 W
CF₄ gas flow rate: 150 sccm
CHF₃ gas flow rate: 50 sccm
Time: 30 sec

**[Table 9]**

| Example | Composition for forming | Etching resistance |
|---|---|---|
| | resist underlayer film | |
| Ex. 2-1 | UL-1 | A |
| Ex. 2-2 | UL-2 | A |
| Ex. 2-3 | UL-3 | A |
| Ex. 2-4 | UL-4 | A |
| Ex. 2-5 | UL-5 | A |
| Ex. 2-6 | UL-6 | A |
| Ex. 2-7 | UL-7 | A |
| Ex. 2-8 | UL-8 | A |
| Ex. 2-9 | UL-9 | A |
| Ex. 2-10 | UL-10 | A |
| Comp. Ex. 2-1 | Comparative Example UL-1 | C |
| Comp. Ex. 2-2 | Comparative Example UL-2 | C |
| Comp. Ex. 2-3 | Comparative Example UL-3 | C |
| Comp. Ex. 2-4 | Comparative Example UL-4 | A |
| Comp. Ex. 2-5 | Comparative Example UL-5 | A |
| Comp. Ex. 2-6 | Comparative Example UL-6 | C |
| Comp. Ex. 2-7 | KrF monolayer resist | C |

As shown in Table 9, it was found that Examples 2-1 to 2-10 using UL-1-1 to 1-10 which are the compositions for forming a resist underlayer film used in the pattern forming method of the present invention exhibit excellent dry-etching resistance compared to Comparative Example 2-7 using the KrF monolayer resist. On the other hand, in Comparative Examples 2-1 to 2-3 and 2-6 using Comparative Examples UL-1 to 3 and UL-6, respectively, which are styrene-type resins different from the compositions for forming a resist underlayer film used in the pattern forming method of the present invention, the dry-etching resistance was insufficient.

### Filling Property (Examples 3-1 to 3-10, Comparative Examples 3-1 to 3-6)

The compositions for forming a resist underlayer film (UL-1 to 10, Comparative Examples UL-1 to 6) used in the above solvent resistance evaluation were each applied on a SiO₂ wafer substrate 7 having a dense hole pattern (hole diameter 0.45 µm, hole depth 11.0 µm, the distance between the centers of two holes adjacent to each other 1.00 µm) as illustrated in FIGS. 2(M) (plan view) and (N) (cross section), and baked at a temperature listed in Table 7 for 60 seconds to form a resist underlayer film 8 as illustrated in FIG. 2(O). The cross-sectional shape of each wafer substrate obtained was observed using a scanning electron microscope (SEM) and checked as to whether there were no voids inside the holes and the holes were filled with the resist underlayer film, without separation at the interface between the pattern sidewall and the resist underlayer film material. The results are listed in Table 10. When a composition for forming a resist underlayer film inferior in filling property is used, voids are produced inside the holes in the present evaluation. When a composition for forming a resist underlayer film inferior in adhesion is used, separation occurs at the interface between the pattern sidewall or the substrate and the resist underlayer film material in the present evaluation. When a composition for forming a resist underlayer film with good filling property and adhesion is used, there are no voids inside the holes and the holes are filled with the resist underlayer film without separation, as illustrated in FIG. 2(O), in the present evaluation.

**[Table 10]**

| Example | Composition for forming | Filling property | |
|---|---|---|---|
| | resist underlayer film | Voids | Separation from substrate |
| Ex. 3-1 | UL-1 | None | None |
| Ex. 3-2 | UL-2 | None | None |
| Ex. 3-3 | UL-3 | None | None |
| Ex. 3-4 | UL-4 | None | None |
| Ex. 3-5 | UL-5 | None | None |
| Ex. 3-6 | UL-6 | None | None |
| Ex. 3-7 | UL-7 | None | None |
| Ex. 3-8 | UL-8 | None | None |
| Ex. 3-9 | UL-9 | None | None |
| Ex. 3-10 | UL-10 | None | None |
| Comp. Ex. 3-1 | Comparative Example UL-1 | Found | None |
| Comp. Ex. 3-2 | Comparative Example UL-2 | None | Found |
| Comp. Ex. 3-3 | Comparative Example UL-3 | None | Found |
| Comp. Ex. 3-4 | Comparative Example UL-4 | Found | None |
| Comp. Ex. 3-5 | Comparative Example UL-5 | None | Found |
| Comp. Ex. 3-6 | Comparative Example UL-6 | Found | None |

As shown in Table 10, Examples 3-1 to 3-10 using UL-1 to 10 which are the compositions for forming a resist underlayer film used in the pattern forming method of the present invention can fill the hole pattern without voids or separation, indicating that the filling property and adhesion were excellent.

On the other hand, in Comparative Examples 3-1, 3-4, and 3-6 using Comparative Examples UL-1, UL-4, and UL-6, voids were produced due to filling failures presumably because a large amount of hydroxyl groups in the resin results in insufficient flowability.

In Comparative Examples 3-2, 3-3, and 3-5 using Comparative Examples UL-2, UL-3, and UL-5, respectively, no voids were produced but separation due to insufficient adhesion was observed. This is presumably because the amount of hydroxyl groups in the resin was insufficient.

### Pattern Forming Method (Examples 4-1 to 4-10, Comparative Examples 4-1 to 4-4)

The compositions for forming a resist underlayer film (UL-1 to 10, Comparative Examples UL-1 to 3) were each applied on a SiO₂ substrate treated with HMDS (90°C × 60 seconds) and baked at 250°C for 60 seconds in the air to form a resist underlayer film with a film thickness of 3,000 nm. A silicon atom-containing resist middle layer film material (SOG-1) was applied thereon and baked at 220°C for 60 seconds to form a resist middle layer film with a film thickness of 45 nm. An ArF monolayer resist as a resist upper layer film material was applied thereon and baked at 105°C for 60 seconds to form a photoresist film with a film thickness of 100 nm.

As the silicon atom-containing resist middle layer film material (SOG-1), a polymer denoted as an ArF silicon-containing middle layer film polymer (SiP1) and a thermal crosslinking catalyst (CAT1) were dissolved in an organic solvent containing 0.1% by mass of FC-4430 (manufactured by Sumitomo 3M Limited) in the proportions listed in Table 11, and the solution was filtered through a fluorinated resin filter with a pore diameter of 0.1 µm to prepare the silicon atom-containing resist middle layer film material (SOG-1).

**[Table 11]**

| | Polymer | Thermal crosslinking catalyst | Organic solvent |
|---|---|---|---|
| | (Parts by mass) | (Parts by mass) | (Parts by mass) |
| SOG-1 | SiP1 (100) | CAT1 (1) | Propylene glycol monoethyl ether (4,000) |

The structural formulae of the ArF silicon-containing middle layer film polymer (SiP1) and the thermal crosslinking catalyst (CAT1) that were used are as follows.

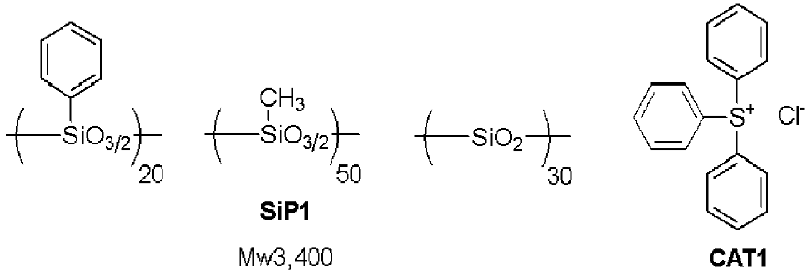

The resist upper layer film material (ArF monolayer resist) was prepared by dissolving a polymer (RP1), an acid generator (PAG1), and a basic compound (Amine1) in a solvent containing 0.1% by mass of a surfactant FC-4430 (manufactured by Sumitomo 3M Limited) in the proportions listed in Table 12, and filtering the solution through a 0.1 µm fluorinated resin filter.

**[Table 12]**

| | Polymer (parts by mass) | Acid generator (parts by mass) | Basic compound (parts by mass) | Solvent (parts by mass) |
|---|---|---|---|---|
| ArF monolayer resist | RP1 (100) | PAG1 (6.6) | Amine1 (0.8) | PGMEA (2,500) |

The polymer (RP1), the acid generator (PAG1), and the basic compound (Amine1) used in the resist upper layer film material (ArF monolayer resist) are as follows.

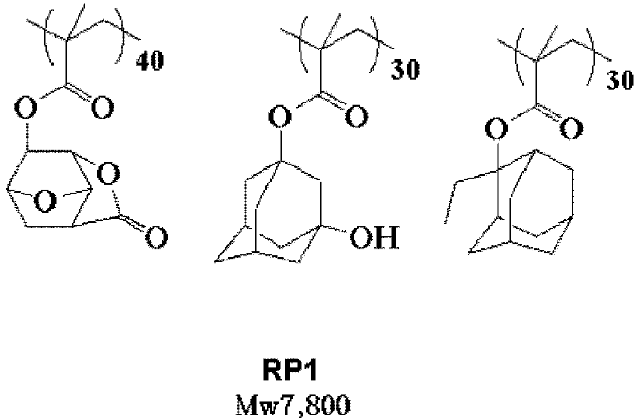

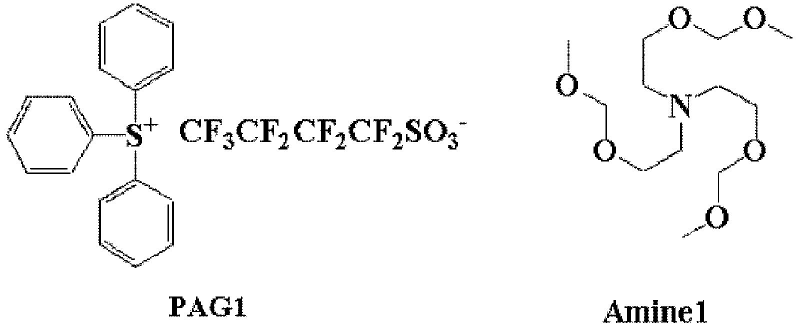

Subsequently, the substrate was exposed using an ArF liquid immersion exposure apparatus (manufactured by Nikon Corporation; NSR-S610C, NA 0.85, σ 0.75, conventional, 6% halftone phase shift mask), baked at 100°C for 60 seconds (PEB), and developed by 2.38% by mass tetramethylammonium hydroxide (TMAH) aqueous solution to obtain a 1:5 positive-type line-and-space pattern (resist pattern) with 0.5 µm.

Subsequently, using an etching apparatus Telius manufactured by Tokyo Electron Limited, the resist middle layer film was etched by dry-etching using the resist pattern as a mask to form a resist middle layer film pattern, the resist underlayer film was etched using the resulting resist middle layer film pattern as a mask to form a resist underlayer film pattern, and the SiO₂ film was etched using the resulting resist underlayer film pattern as a mask. The etching conditions are as follows.

Conditions for Transferring Resist Pattern to Resist Middle Layer Film
Chamber pressure: 80 mT
RF power (upper): 500 W
RF power (lower): 300 W
CF₄ gas flow rate: 150 sccm
CHF₃ gas flow rate: 50 sccm
Time: 35 sec

Conditions for Transferring Resist Middle Layer Film Pattern to Resist Underlayer Film
Chamber pressure: 80 mT
RF power (upper): 500 W
RF power (lower): 300 W
CO₂ gas flow rate: 320 sccm
N₂ gas flow rate: 80 sccm
Time: 900 sec

Conditions for Transferring Resist Underlayer Film Pattern to SiO₂ Film
Chamber pressure: 10 mT
RF power (upper): 100 W
RF power (lower): 800 W
CF₄ gas flow rate: 25 sccm
CHF₃ gas flow rate: 15 sccm
O₂ gas flow rate: 5 sccm
Time: 900 sec

As Comparative Example 4-4, a comparative example KrF resist material (KrF monolayer resist) was applied on a SiO₂ substrate having a BARC (DUV-42/61 nm) deposited thereon, baked at 130°C for 90 seconds in the air to form a resist film with a film thickness of 3,000 nm. Subsequently, the substrate was exposed using a KrF exposure apparatus (manufactured by Nikon Corporation; NSR-S203B (NA=0.55, σ 0.75, conventional, binary mask), baked at 100°C for 60 seconds (PEB), and developed by 2.38% by mass tetramethylammonium hydroxide (TMAH) aqueous solution to obtain a 1:5 positive-type line-and-space pattern (resist pattern) with 0.5 µm.

A comparative example KrF resist material (KrF monolayer resist) similar to the above was used.

Subsequently, using an etching apparatus Telius manufactured by Tokyo Electron Limited, the SiO₂ film was etched by dry-etching using the resist pattern as a mask. The etching conditions are as follows.

Conditions for Transferring Resist Pattern to SiO₂ Film
Chamber pressure: 10 mT
RF power (upper): 100 W
RF power (lower): 800 W
CF₄ gas flow rate: 25 sccm
CHF₃ gas flow rate: 15 sccm
O₂ gas flow rate: 5 sccm
Time: 900 sec

The pattern cross sections were observed with an electron microscope (S-4700) manufactured by Hitachi, Ltd. The results are listed in Table 13.

**[Table 13]**

| Example | Composition for forming | After substrate processing |
|---|---|---|
| | resist underlayer film | Pattern shape |
| Ex. 4-1 | UL-1 | Perpendicular |
| Ex. 4-2 | UL-2 | Perpendicular |
| Ex. 4-3 | UL-3 | Perpendicular |
| Ex. 4-4 | UL-4 | Perpendicular |
| Ex. 4-5 | UL-5 | Perpendicular |
| Ex. 4-6 | UL-6 | Perpendicular |
| Ex. 4-7 | UL-7 | Perpendicular |
| Ex. 4-8 | UL-8 | Perpendicular |
| Ex. 4-9 | UL-9 | Perpendicular |
| Ex. 4-10 | UL-10 | Perpendicular |
| Comp. Ex. 4-1 | Comparative Example UL-1 | Tapered |
| Comp. Ex. 4-2 | Comparative Example UL-2 | Tapered |
| Comp. Ex. 4-3 | Comparative Example UL-3 | Tapered |
| Comp. Ex. 4-4 | KrF monolayer resist | Tapered |

As shown in Table 13, in all of Examples 4-1 to 4-10 using UL-1 to 10 which are the compositions for forming a resist underlayer film used in the pattern forming method of the present invention, it was found that the resist upper layer film pattern was transferred well to the substrate to be processed.

On the other hand, in Comparative Examples 4-1 to 4-3 using Comparative Examples UL-1 to 3, and Comparative Example 4-4 using the KrF monolayer resist, it was found that the pattern transferred to the substrate to be processed had a tapered shape. This is presumably because the resistance against dry-etching using CF₄/CHF₃ gas was insufficient in the dry-etching resistance evaluation.

The above evaluation was conducted for comparing the performance of pattern transfer to the substrate to be processed of the mask material used for processing the substrate to be processed, and it was found that the pattern forming method of the present invention (Examples 4-1 to 4-10) is excellent in performance of pattern transfer to the substrate to be processed. In other words, the pattern forming method of the present invention has sufficient resistance for a complicated etching process of repeating etching of the substrate to be processed and trimming of the mask material, such as forming a staircase-shaped pattern in the substrate to be processed, as typified by 3D NAND memories.

### Pattern Forming Method (Examples 5-1 to 5-10, Comparative Examples 5-1 to 5-3)

The compositions for forming a resist underlayer film for thick film formation (TUL-1 to 10, Comparative Examples TUL-1 to 3) prepared as listed in Table 14 below were each applied on a SiO₂ substrate treated with HMDS (90°C × 60 seconds) and baked at 250°C for 60 seconds in the air to form a resist underlayer film with a film thickness of 10,000 nm. A silicon atom-containing resist middle layer film material (SOG-2) was applied thereon and baked at 220°C for 60 seconds to form a resist middle layer film with a film thickness of 150 nm. An ArF monolayer resist as a resist upper layer film material was applied thereon and baked at 105°C for 60 seconds to form a photoresist film with a film thickness of 200 nm.

**[Table 14]**

| Composition for forming resist underlayer film | Resin (A) | Base generator (C) | Crosslinking agent (D) | Flowability promotor (E) | Organic solvent (B) |
|---|---|---|---|---|---|
| for thick film formation | (parts by mass) | (parts by mass) | (parts by mass) | (parts by mass) | (parts by mass) |
| TUL-1 | (X-1) (100) | - | - | - | PGMEA (140) |
| TUL-2 | (X-2) (100) | - | - | - | PGMEA (140) |
| TUL-3 | (X-3) (100) | - | - | - | PGMEA (140) |
| TUL-4 | (X-4) (100) | - | - | - | PGMEA (140) |
| TUL-5 | (X-5) (100) | (C-1) (0.5) | - | - | PGMEA (140) |
| TUL-6 | (X-6) (100) | (C-2) (0.5) | - | - | PGMEA (140) |
| TUL-7 | (X-7) (100) | (C-3) (0.5) | - | - | PGMEA (140) |
| TUL-8 | (X-8) (100) | (C-4) (0.5) | - | - | PGMEA (140) |
| TUL-9 | (X-9) (100) | - | D-1 (30) | - | PGMEA (140) |
| TUL-10 | (R-4) / (R-5) (50/50) | - | - | E-1 (30) | PGMEA (140) |
| Comp. Ex. TUL-1 | (R-1) (100) | - | - | - | PGMEA (140) |
| Comp. Ex. TUL-2 | (R-2) (100) | - | - | - | PGMEA (140) |
| Comp. Ex. TUL-3 | (R-3) (100) | - | - | - | PGMEA (140) |

As the silicon atom-containing resist middle layer film material (SOG-2), a polymer denoted as an ArF silicon-containing middle layer film polymer (SiP1) and a thermal crosslinking catalyst (CAT1) were dissolved in an organic solvent containing 0.1% by mass of FC-4430 (manufactured by Sumitomo 3M Limited) in the proportions listed in Table 15, and the solution was filtered through a fluorinated resin filter with a pore diameter of 0.1 µm to prepare the silicon atom-containing resist middle layer film material (SOG-2).

**[Table 15]**

| | Polymer | Thermal crosslinking catalyst | Organic solvent |
|---|---|---|---|
| | (parts by mass) | (parts by mass) | (parts by mass) |
| SOG-2 | SiP1 | CAT1 | PGMEA |
| | 100 | 1 | 1,200 |

The ArF silicon-containing middle layer film polymer (SiP1) and the thermal crosslinking catalyst (CAT1) that were used are same the above.

The resist upper layer film material (ArF monolayer resist) was prepared by dissolving a polymer (RP1), an acid generator (PAG1), and a basic compound (Amine1) in a solvent containing 0.1% by mass of a surfactant FC-4430 (manufactured by Sumitomo 3M Limited) in the proportions listed in Table 16, and filtering the solution through a 0.1 µm fluorinated resin filter.

**[Table 16]**

| | Polymer | Acid generator | Basic compound | Solvent |
|---|---|---|---|---|
| | (parts by mass) | (parts by mass) | (parts by mass) | (parts by mass) |
| ArF monolayer resist | PR1 | PAG1 | Amine1 | PGMEA |
| | 100 | 6.6 | 0.8 | 2,000 |

The polymer (RP1), the acid generator (PAG1), and the basic compound (Amine1) used in the resist upper layer film material (ArF monolayer resist) are same the above.

Subsequently, the substrate was exposed using an ArF liquid immersion exposure apparatus (manufactured by Nikon Corporation; NSR-S610C, NA 0.85, σ 0.75, conventional, 6% halftone phase shift mask), baked at 100°C for 60 seconds (PEB), and developed by 2.38% by mass tetramethylammonium hydroxide (TMAH) aqueous solution to obtain a 1:1 positive-type space-and-line pattern (resist pattern) with 5 µm.

Subsequently, using an etching apparatus Telius manufactured by Tokyo Electron Limited, the resist middle layer film was etched by dry-etching using the resist pattern as a mask to form a resist middle layer film pattern, the resist underlayer film was etched using the resulting resist middle layer film pattern as a mask to from a resist underlayer film pattern, and the SiO₂ film was etched using the resulting resist underlayer film pattern as a mask. The etching conditions are as follows.

Conditions for Transferring Resist Pattern to Resist Middle Layer Film
Chamber pressure: 80 mT
RF power (upper): 500 W
RF power (lower): 300 W
CF₄ gas flow rate: 150 sccm
CHF₃ gas flow rate: 50 sccm
Time: 70 sec

Conditions for Transferring Resist Middle Layer Film Pattern to Resist Underlayer Film
Chamber pressure: 80 mT
RF power (upper): 500 W
RF power (lower): 300 W
CO₂ gas flow rate: 320 sccm
N₂ gas flow rate: 80 sccm
Time: 2,100 sec

Conditions for Transferring Resist Underlayer Film Pattern to SiO₂ Film
Chamber pressure: 10 mT
RF power (upper): 100 W
RF power (lower): 800 W
CF₄ gas flow rate: 25 sccm
CHF₃ gas flow rate: 15 sccm
O₂ gas flow rate: 5 sccm
Time: 900 sec

The pattern cross sections were observed with an electron microscope (S-4700) manufactured by Hitachi, Ltd. The results are listed in Table 17.

**[Table 17]**

| Example | Composition for forming resist underlayer film | Pattern shape after processing |
|---|---|---|
| | for thick film formation | resist underlayer film |
| Ex. 5-1 | TUL-1 | Perpendicular |
| Ex. 5-2 | TUL-2 | Perpendicular |
| Ex. 5-3 | TUL-3 | Perpendicular |
| Ex. 5-4 | TUL-4 | Perpendicular |
| Ex. 5-5 | TUL-5 | Perpendicular |
| Ex. 5-6 | TUL-6 | Perpendicular |
| Ex. 5-7 | TUL-7 | Perpendicular |
| Ex. 5-8 | TUL-8 | Perpendicular |
| Ex. 5-9 | TUL-9 | Perpendicular |
| Ex. 5-10 | TUL-10 | Perpendicular |
| Comp. Ex. 5-1 | Comp. Ex. TUL-1 | Tapered |
| Comp. Ex. 5-2 | Comp. Ex. TUL-2 | Tapered Substrate separated |
| Comp. Ex. 5-3 | Comp. Ex. TUL-3 | Tapered Substrate separated |

As shown in Table 17, in all of Examples 5-1 to 5-10 using TUL-1 to 10 which are the compositions for forming a resist underlayer film for thick film formation used in the pattern forming method of the present invention, it was found that the resist upper layer film pattern was transferred well to the substrate to be processed. Defects such as separation at the interface between the resist underlayer film and the substrate were not found.

On the other hand, in Comparative Examples 5-1 to 5-3 using Comparative Examples TUL-1 to 3, it was found that the resist underlayer film pattern had a tapered shape. This is presumably because the resistance against dry-etching using CF₄/CHF₃ gas was insufficient in the above dry-etching resistance evaluation. Further, in Comparative Examples 5-2 to 5-3, it was found that the resist underlayer film pattern was separated from the substrate interface. This is presumably because the amount of hydroxyl groups in the resin is insufficient.

As indicated by the above results, the pattern forming method of the present invention is a method using a composition for forming a resist underlayer film capable of forming a thick film and having both high filling property and substrate adhesion, and exhibits excellent resist pattern transfer performance compared to the pattern forming method using a KrF resist material of a single layer. Thus, it is possible to provide a pattern forming method suitable for forming a staircase-shaped pattern in a substrate to be processed, as typified by 3D NAND memories.

The present description includes the following embodiments.
[1]: A pattern forming method in which a pattern is formed in a substrate to be processed, the pattern forming method comprising steps of:
   (I-1) applying a composition for forming a resist underlayer film on a substrate to be processed and thereafter performing heat treatment to form a resist underlayer film;
   (I-2) forming a silicon-containing resist middle layer film on the resist underlayer film;
   (I-3) forming a resist upper layer film by using a photoresist material on the silicon-containing resist middle layer film;
   (I-4) performing pattern exposure and subsequent development with a developer in the resist upper layer film to form a pattern in the resist upper layer film;
   (I-5) transferring a pattern to the silicon-containing resist middle layer film by dry-etching while using the resist upper layer film having the pattern as a mask;
   (I-6) transferring a pattern to the resist underlayer film by dry-etching while using the silicon-containing resist middle layer film having the transferred pattern as a mask;
   (I-7) processing the substrate to be processed while using the resist underlayer film having the transferred pattern as a mask to form a pattern in the substrate to be processed;
   (I-8) trimming the resist underlayer film having the transferred pattern; and
   (I-9) processing the substrate to be processed while using the trimmed resist underlayer film pattern as a mask to form a staircase-shaped pattern in the substrate to be processed, wherein
      the composition for forming a resist underlayer film contains a resin (A) and an organic solvent (B), the resin (A) has a constitutional unit represented by the following general formula (1), and when a phenolic hydroxyl group contained in the resin (A) has a proportion "a" and a group in which a phenolic hydroxyl group is modified has a proportion "b", a relation: a+b=1, 0.1≤a≤0.5, and 0.5≤b≤0.9 is satisfied, 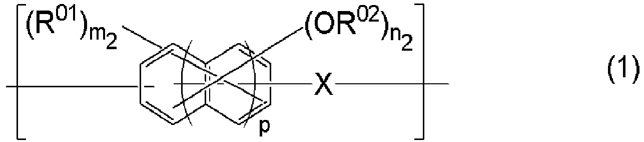
      wherein R⁰¹ represents an optionally substituted saturated or unsaturated monovalent organic group having 1 to 30 carbon atoms; R⁰² represents a hydrogen atom or an optionally substituted saturated or unsaturated monovalent organic group having 1 to 30 carbon atoms; X represents a divalent organic group having 1 to 30 carbon atoms; "p" represents 0 or 1, wherein when "p" is 0, "m₂" represents an integer of 0 to 3, "n₂" represents an integer of 1 to 4, and m₂+n₂ represents an integer of 1 or greater and 4 or smaller, and when "p" is 1, "m₂" represents an integer of 0 to 5, "n₂" represents an integer of 1 to 6, and m₂+n₂ represents an integer of 1 or greater and 6 or smaller.
[2]: The pattern forming method of the above [1], wherein the steps (I-8) to (I-9) are repeated to form a plurality of staircase-shaped patterns in the substrate to be processed.
[3]: The pattern forming method of the above [1] or [2], wherein a multilayer film having stacked polysilicon layers, or a multilayer film having a SiN layer and a SiO layer alternately stacked is used as the substrate to be processed.
[4]: The pattern forming method of any one of the above [1] to [3], wherein a multilayer film having a polysilicon layer and a SiO layer alternately stacked, or a multilayer film having a SiN layer and a SiO layer alternately stacked is used as the substrate to be processed.
[5]: The pattern forming method of any one of the above [1] to [4], wherein a resist underlayer film having a thickness of at least 3 µm is formed as the resist underlayer film.
[6]: The pattern forming method of the above [5], wherein in the step (I-1), the resist underlayer film is coated to a thickness of at least 3 µm in one application.
[7]: The pattern forming method of any one of the above [1] to [6], wherein a resin having a weight average molecular weight of 3,000 to 20,000 is used as the resin (A).
[8]: The pattern forming method of any one of the above [1] to [7], wherein a composition containing a base generator (C) is used as the composition for forming a resist underlayer film.
[9]: The pattern forming method of the above [8], wherein any one represented by the following general formulae (2), (3), and (4) is used as the base generator (C), 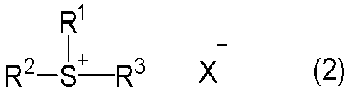 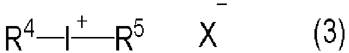 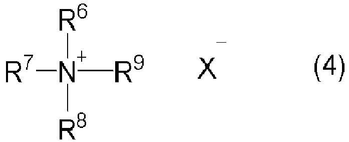 wherein R¹ to R³ each independently represent a linear, branched, or cyclic alkyl group having 1 to 10 carbon atoms or alkenyl group having 2 to 10 carbon atoms, which may be substituted with or separated by a hetero atom, or represent an aryl group having 6 to 18 carbon atoms or aralkyl group having 7 to 18 carbon atoms, which may be substituted with or separated by a hetero atom; any two of R¹, R², and R³ may bond together to form a ring with a sulfur atom in the formula; X⁻represents an organic or inorganic anion serving as a pairing ion, provided that X⁻ does not include OH⁻; R⁴ and R⁵ are each independently an aryl group having 6 to 20 carbon atoms, which may be substituted with or separated by a hetero atom, in which part or all of hydrogen atoms may be substituted with a linear, branched, or cyclic alkyl group or alkoxy group having 1 to 10 carbon atoms; R⁴ and R⁵ may bond together to form a ring with an iodine atom in the formula; R⁶, R⁷, R⁸, and R⁹ each independently represent a hydrogen atom, or a linear, branched, or cyclic alkyl group having 1 to 20 carbon atoms or alkenyl group having 2 to 20 carbon atoms, which may be substituted with or separated by a hetero atom, or represent an aryl group having 6 to 18 carbon atoms or aralkyl group having 7 to 18 carbon atoms, which may be substituted with or separated by a hetero atom; and any two or more of R⁶, R⁷, R⁸, and R⁹ may bond together to form a ring with a nitrogen atom in the formula.
[10]: The pattern forming method of the above [9], wherein one of: a structure represented by any one of the following general formulae (5), (6), and (7); and an anion selected from the group consisting of chloride ion, bromide ion, iodide ion, fluoride ion, cyanide ion, nitrate ion, and nitrite ion is used as X⁻ in the general formulae (2), (3), and (4),

   R¹⁰-COO (5)

   R¹¹-SO₃ (6)

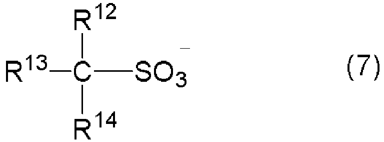

   wherein R¹⁰ represents a linear, branched, or cyclic alkyl group having 1 to 20 carbon atoms, alkenyl group having 2 to 20 carbon atoms, aryl group having 6 to 20 carbon atoms, or aralkyl group having 7 to 20 carbon atoms, which may contain one or more selected from an ether group, an ester group, and a carbonyl group, and part or all of hydrogen atoms in these groups may be substituted with one or more selected from a halogen atom, a hydroxyl group, a carboxy group, an amino group, and a cyano group; R¹¹ represents an aryl group having 6 to 20 carbon atoms, and part or all of hydrogen atoms in the aryl group may be substituted with one or more selected from a halogen atom, a hydroxyl group, a carboxy group, an amino group, and a cyano group; R¹², R¹³, and R¹⁴ each independently represent a hydrogen atom, a halogen atom except fluorine atom, or a linear, branched, or cyclic alkyl group having 1 to 20 carbon atoms, alkenyl group having 2 to 20 carbon atoms, aryl group having 6 to 20 carbon atoms, or aralkyl group having 7 to 20 carbon atoms, which may contain one or more selected from an ether group, an ester group, and a carbonyl group, and part or all of hydrogen atoms in these groups may be substituted with one or more selected from a halogen atom, a hydroxyl group, a carboxy group, an amino group, and a cyano group; and two or more of R¹², R¹³, and R¹⁴ may bond together to form a ring.
[11]: The pattern forming method of any one of the above [1] to [10], wherein in the general formula (1), R⁰² represents any one of a hydrogen atom, an alkyl group having 1 to 10 carbon atoms, and a structure represented by the following general formulae (8), 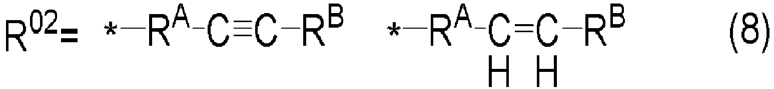 wherein * represents a bonding site with an oxygen atom; R^{A} represents an optionally substituted divalent organic group having 1 to 10 carbon atoms; and R^{B} represents a hydrogen atom or an optionally substituted monovalent organic group having 1 to 10 carbon atoms.
[12]: The pattern forming method of any one of the above [1] to [11], wherein a composition further containing one or more selected from a crosslinking agent (D), a flowability accelerator (E), and a surfactant (F) is used as the composition for forming a resist underlayer film.
[13]: The pattern forming method of any one of the above [1] to [12], wherein photolithography with a wavelength of 5 nm to 300 nm, direct drawing by electron beams, nano-imprinting, or a combination thereof is used as a method of forming a circuit pattern in the resist upper layer film.
[14]: The pattern forming method of any one of the above [1] to [13], wherein alkaline development or development by an organic solvent is used as a development method.
[15]: The pattern forming method of any one of the above [1] to [14], wherein a substrate having a structure or a step with an aspect ratio of 5 or more is used as the substrate to be processed.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A pattern forming method in which a pattern is formed in a substrate to be processed, the pattern forming method comprising steps of:
(I-1) applying a composition for forming a resist underlayer film on a substrate to be processed and thereafter performing heat treatment to form a resist underlayer film;
(I-2) forming a silicon-containing resist middle layer film on the resist underlayer film;
(I-3) forming a resist upper layer film by using a photoresist material on the silicon-containing resist middle layer film;
(I-4) performing pattern exposure and subsequent development with a developer in the resist upper layer film to form a pattern in the resist upper layer film;
(I-5) transferring a pattern to the silicon-containing resist middle layer film by dry-etching while using the resist upper layer film having the pattern as a mask;
(I-6) transferring a pattern to the resist underlayer film by dry-etching while using the silicon-containing resist middle layer film having the transferred pattern as a mask;
(I-7) processing the substrate to be processed while using the resist underlayer film having the transferred pattern as a mask to form a pattern in the substrate to be processed;
(I-8) trimming the resist underlayer film having the transferred pattern; and
(I-9) processing the substrate to be processed while using the trimmed resist underlayer film pattern as a mask to form a staircase-shaped pattern in the substrate to be processed, wherein
the composition for forming a resist underlayer film contains a resin (A) and an organic solvent (B), the resin (A) has a constitutional unit represented by the following general formula (1), and when a phenolic hydroxyl group contained in the resin (A) has a proportion "a" and a group in which a phenolic hydroxyl group is modified has a proportion "b", a relation: a+b=1, 0.1≤a≤0.5, and 0.5≤b≤0.9 is satisfied, 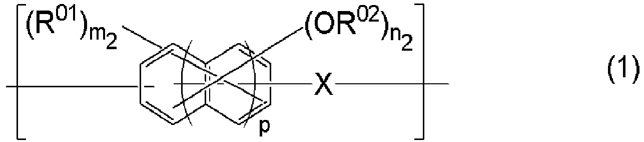
wherein R⁰¹ represents an optionally substituted saturated or unsaturated monovalent organic group having 1 to 30 carbon atoms; R⁰² represents a hydrogen atom or an optionally substituted saturated or unsaturated monovalent organic group having 1 to 30 carbon atoms; X represents a divalent organic group having 1 to 30 carbon atoms; "p" represents 0 or 1, wherein when "p" is 0, "m₂" represents an integer of 0 to 3, "n₂" represents an integer of 1 to 4, and m₂+n₂ represents an integer of 1 or greater and 4 or smaller, and when "p" is 1, "m₂" represents an integer of 0 to 5, "n₂" represents an integer of 1 to 6, and m₂+n₂ represents an integer of 1 or greater and 6 or smaller.

2. The pattern forming method according to claim 1, wherein the steps (I-8) to (I-9) are repeated to form a plurality of staircase-shaped patterns in the substrate to be processed.

3. The pattern forming method according to claim 1 or 2, wherein a multilayer film having stacked polysilicon layers, or a multilayer film having a SiN layer and a SiO layer alternately stacked is used as the substrate to be processed.

4. The pattern forming method according to any one of claims 1 to 3, wherein a multilayer film having a polysilicon layer and a SiO layer alternately stacked, or a multilayer film having a SiN layer and a SiO layer alternately stacked is used as the substrate to be processed.

5. The pattern forming method according to any one of claims 1 to 4, wherein a resist underlayer film having a thickness of at least 3 µm is formed as the resist underlayer film.

6. The pattern forming method according to claim 5, wherein in the step (I-1), the resist underlayer film is coated to a thickness of at least 3 µm in one application.

7. The pattern forming method according to any one of claims 1 to 6, wherein a resin having a weight average molecular weight of 3,000 to 20,000 is used as the resin (A) .

8. The pattern forming method according to any one of claims 1 to 7, wherein a composition containing a base generator (C) is used as the composition for forming a resist underlayer film.

9. The pattern forming method according to claim 8, wherein any one represented by the following general formulae (2), (3), and (4) is used as the base generator (C), 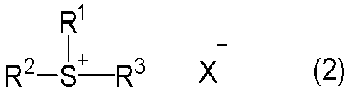 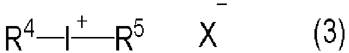 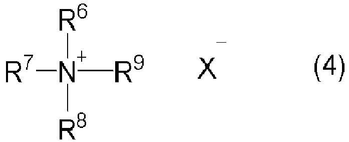 wherein R¹ to R³ each independently represent a linear, branched, or cyclic alkyl group having 1 to 10 carbon atoms or alkenyl group having 2 to 10 carbon atoms, which may be substituted with or separated by a hetero atom, or represent an aryl group having 6 to 18 carbon atoms or aralkyl group having 7 to 18 carbon atoms, which may be substituted with or separated by a hetero atom; any two of R¹, R², and R³ may bond together to form a ring with a sulfur atom in the formula; X⁻represents an organic or inorganic anion serving as a pairing ion, provided that X⁻ does not include OH⁻; R⁴ and R⁵ are each independently an aryl group having 6 to 20 carbon atoms, which may be substituted with or separated by a hetero atom, in which part or all of hydrogen atoms may be substituted with a linear, branched, or cyclic alkyl group or alkoxy group having 1 to 10 carbon atoms; R⁴ and R⁵ may bond together to form a ring with an iodine atom in the formula; R⁶, R⁷, R⁸, and R⁹ each independently represent a hydrogen atom, or a linear, branched, or cyclic alkyl group having 1 to 20 carbon atoms or alkenyl group having 2 to 20 carbon atoms, which may be substituted with or separated by a hetero atom, or represent an aryl group having 6 to 18 carbon atoms or aralkyl group having 7 to 18 carbon atoms, which may be substituted with or separated by a hetero atom; and any two or more of R⁶, R⁷, R⁸, and R⁹ may bond together to form a ring with a nitrogen atom in the formula.

10. The pattern forming method according to claim 9, wherein one of: a structure represented by any one of the following general formulae (5), (6), and (7); and an anion selected from the group consisting of chloride ion, bromide ion, iodide ion, fluoride ion, cyanide ion, nitrate ion, and nitrite ion is used as X⁻ in the general formulae (2), (3), and (4),
R¹⁰-COO (5)
R¹¹-SO₃⁻ (6) 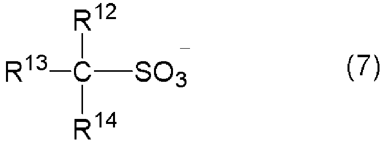
wherein R¹⁰ represents a linear, branched, or cyclic alkyl group having 1 to 20 carbon atoms, alkenyl group having 2 to 20 carbon atoms, aryl group having 6 to 20 carbon atoms, or aralkyl group having 7 to 20 carbon atoms, which may contain one or more selected from an ether group, an ester group, and a carbonyl group, and part or all of hydrogen atoms in these groups may be substituted with one or more selected from a halogen atom, a hydroxyl group, a carboxy gropu, an amoni group, and a cyano group; R¹¹ represents an aryl group having 6 to 20 carbon atoms, and part or all of hydrogen atoms in the aryl group may be substituted with one or more selected from a halogen atom, a hydroxyl group, a carboxy group, an amino group, and a cyano group; R¹², R¹³, and R¹⁴ each independently represent a hydrogen atom, a halogen atom except fluorine atom, or a linear, branched, or cyclic alkyl group having 2 to 20 carbon atoms, aryl group having 6 to 20 carbon atoms, or aralkyl group having 7 to 20 carbon atoms, which may contain one or more selected from an ether group, an ester group, and a carbonyl group, and part or all of hydrogen atoms in these groups may be substituted with one or more selected from a halogen atom, a hydrxyl group, a carboxyl group, an amino group, and a cyano group; and two or more of R¹², R¹³, and R¹⁴ may bond together to form a ring.

11. The pattern forming method according to any one of claims 1 to 10, wherein in the general formula (1), R⁰² represents any one of a hydrogen atom, an alkyl group having 1 to 10 carbon atoms, and a structure represented by the following general formulae (8), 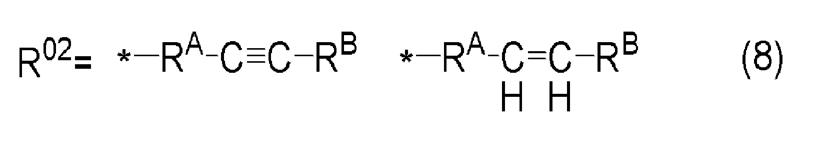 wherein * represents a bonding site with an oxygen atom; R^{A} represents an optionally substituted divalent organic group having 1 to 10 carbon atoms; and R³ represents a hydrogen atom or an optionally substituted monovalent organic group having 1 to 10 carbon atoms.

12. The pattern forming method according to any one of claims 1 to 11, wherein a composition further containing one or more selected from a crosslinking agent (D), a flowability accelerator (E), and a surfactant (F) is used as the composition for forming a resist underlayer film.

13. The pattern forming method according to any one of claims 1 to 12, wherein photolithography with a wavelength of 5 nm to 300 nm, direct drawing by electron beams, nano-imprinting, or a combination thereof is used as a method of forming a circuit pattern in the resist upper layer film.

14. The pattern forming method according to any one of claims 1 to 13, wherein alkaline development or development by an organic solvent is used as a development method.

15. The pattern forming method according to any one of claims 1 to 14, wherein a substrate having a structure or a step with an aspect ratio of 5 or more is used as the substrate to be processed.
